# EUROPEAN PATENT SPECIFICATION

(11) **EP 4 123 709 B1**
(45) Date of publication and mention of the grant of the patent: **22.04.2026**
(21) Application number: 21771837.8
(22) Date of filing: 11.02.2021
(51) Int. Cl.: H04N 25/78, H10F 39/12, H10F 39/00

(54) **IMAGING DEVICE AND ELECTRONIC INSTRUMENT**
BILDGEBUNGSVORRICHTUNG UND ELEKTRONISCHES INSTRUMENT
DISPOSITIF D'IMAGERIE ET INSTRUMENT ÉLECTRONIQUE

(30) Priority: 17.03.2020 JP 2020046223
(43) Date of publication of application: 25.01.2023
(73) Proprietor: Sony Semiconductor Solutions Corporation, Atsugi-shi Kanagawa 243-0014 (JP)
(72) Inventor: KINO, Masashi, Kikuchi-gun, Kumamoto 869-1102 (JP); WATANABE, Takashi, Kikuchi-gun, Kumamoto 869-1102 (JP); YAMAGUCHI, Kazuki, Kikuchi-gun, Kumamoto 869-1102 (JP); KASAHARA, Norikazu, Kikuchi-gun, Kumamoto 869-1102 (JP); SUZUKI, Kohei, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2021/005128
(87) International publication number: WO 2021/186969

(56) References cited:
- EP-A1- 3 439 040
- WO-A1-2011/030391
- WO-A1-2017/187720
- WO-A1-2019/130963
- JP-A- 2014 072 418
- JP-A- 2016 105 474
- JP-A- 2017 027 982
- US-A1- 2018 261 638
- US-A1- 2021 021 778

## Description

### [Technical Field]

The present disclosure relates to an imaging device and an electronic device.

### [Background Art]

United States Patent Application Publication US 2018/262638 A1 provides a MOS field-effect transistor for an imaging device that includes a gate electrode shaped in such that a potential at a border between the element isolation region and the active region becomes shallower than a potential a channel center part.

International Patent Application Publication WO 2019/130963 A1 is directed to a solid-state imaging element, including a transistor that configures a comparator. The transistor may have a multi-finger structure, in which a plurality of field effect transistors is connected in parallel. In an imaging device, an analog-digital converter is mounted as one of the peripheral circuits of a pixel array part. The analog-digital converter converts an analog signal, which is read from each pixel of the pixel array part, into a digital signal. In the analog-digital converter, a comparator that compares an analog signal from a pixel with a reference signal is used (for example, see PTL 1).

### [Citation List]

### [Patent Literature]

[PTL 1]
JP 2014-17838A

### [Summary]

### [Technical Problem]

In the peripheral circuits of the imaging device, the layout of circuit elements needs to shrink in order to achieve lower power consumption and a smaller area. In response to the need, for example, if the layout of a differential transistor used for the comparator is shrunk in the analog-digital converter, random noise increases.

An object of the present disclosure is to provide an imaging device capable of shrinking the layout of circuit elements without increasing random noise, and an electronic device including the imaging device.

### [Solution to Problem]

According to a first aspect, the present invention provides an imaging device according to independent claim 1. Further aspects of the invention are set forth in the dependent claims, the drawings, and the following description. A first imaging device according to the present disclosure for attaining the object includes:
a pixel array part in which pixels are disposed, the pixel including a photoelectric conversion element; and
an analog-digital converter that converts an analog signal outputted from each of the pixels of the pixel array part into a digital signal,
wherein
the analog-digital converter includes a comparator that compares, with a reference signal, the analog signal outputted from each of the pixels of the pixel array part, and a transistor constituting the comparator has a three-dimensional structure including a channel parallel to or perpendicular to a direction of a current flow.

Furthermore, the first electronic device according to the present disclosure for attaining the object includes:
a pixel array part in which pixels are disposed, the pixel including a photoelectric conversion element; and
an analog-digital converter that converts an analog signal outputted from each of the pixels of the pixel array part into a digital signal,
wherein
the analog-digital converter includes a comparator that compares, with a reference signal, the analog signal outputted from each of the pixels of the pixel array part, and a transistor constituting the comparator has a three-dimensional structure including a channel parallel to or perpendicular to a direction of a current flow.

A second imaging device according to the present disclosure for attaining the object includes:
a pixel array part in which pixels are disposed, the pixel including a photoelectric conversion element; and
a constant-current source circuit part having a constant-current source connected to a vertical signal line provided for a column array of the pixel array part,
wherein
a transistor constituting the constant-current source has a three-dimensional structure including a channel perpendicular to a direction of a current flow.

Furthermore, the second electronic device according to the present disclosure for attaining the object includes:
a pixel array part in which pixels are disposed, the pixel including a photoelectric conversion element; and
a constant-current source circuit part having a constant-current source connected to a vertical signal line provided for a column array of the pixel array part,
wherein
a transistor constituting the constant-current source has a three-dimensional structure including a channel perpendicular to a direction of a current flow.

### [Brief Description of Drawings]

[Fig. 1]

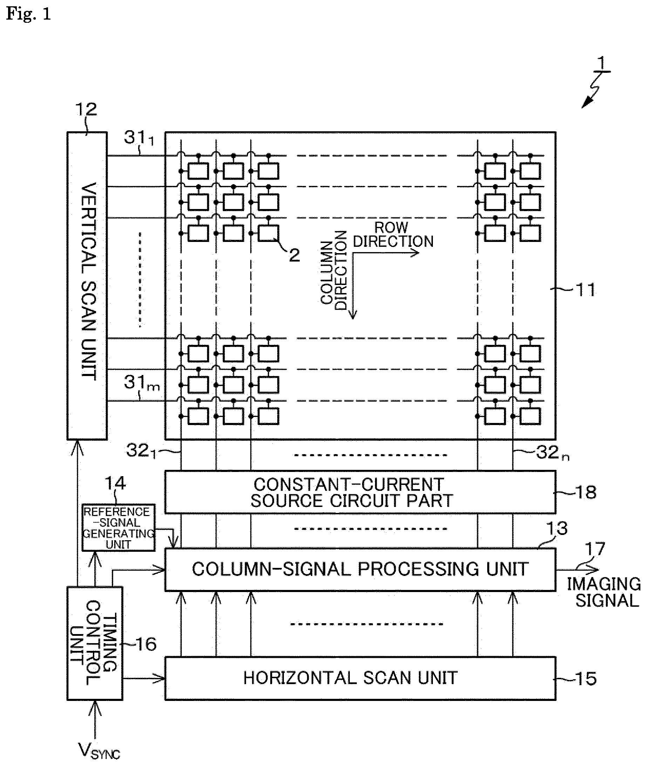

   Fig. 1 is a block diagram schematically illustrating the basic system configuration of a CMOS image sensor as an example of an imaging device according to the present disclosure.
[Fig. 2]

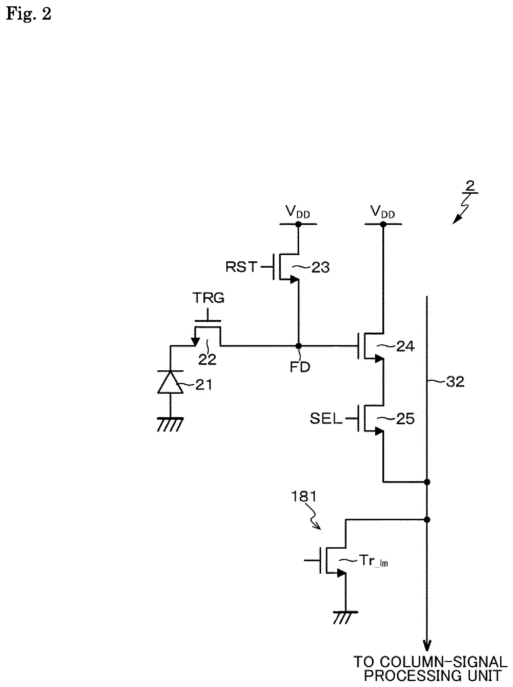

   Fig. 2 is a circuit diagram illustrating an example of a circuit configuration of a pixel.
[Fig. 3]

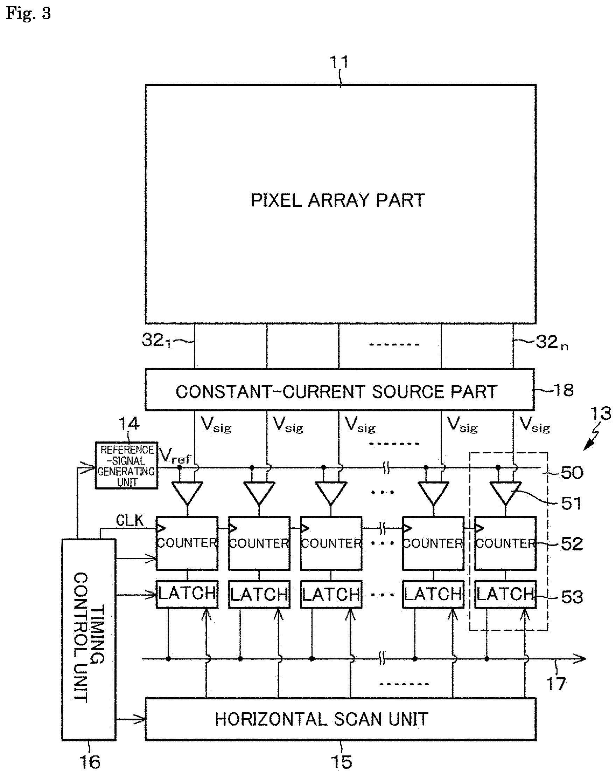

   Fig. 3 is a block diagram illustrating a configuration example of a column parallel analog-digital conversion unit.
[Fig. 4]

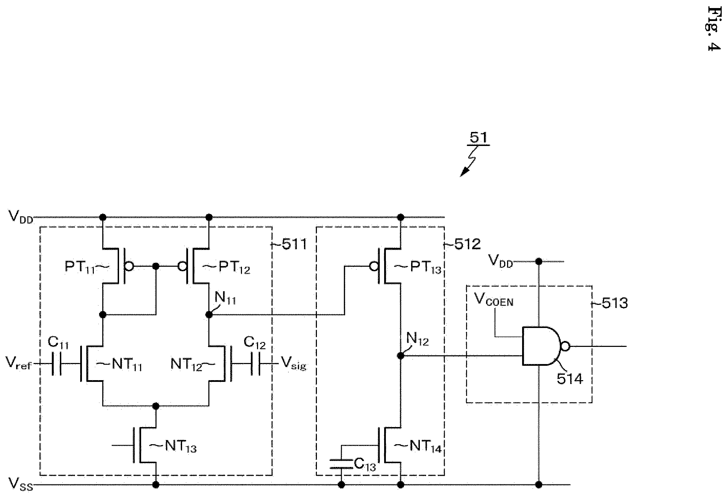

   Fig. 4 is a circuit diagram illustrating an example of a circuit configuration of a comparator.
[Fig. 5]

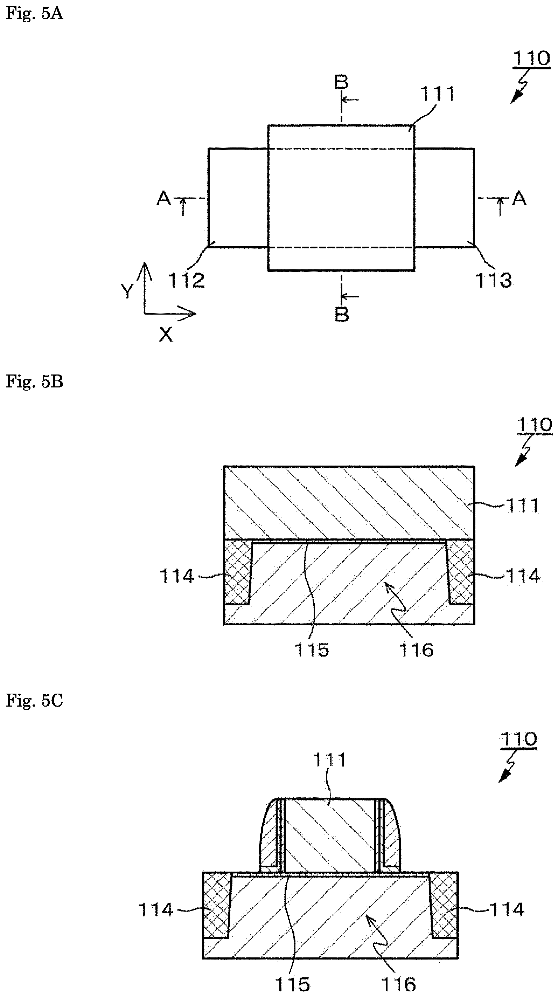

   Fig. 5A is a plan view of a planar transistor, Fig. 5B is a cross-sectional view taken along line A-A of Fig. 5A, and Fig. 5C is a cross-sectional view taken along line B-B of Fig. 5A.
[Fig. 6]

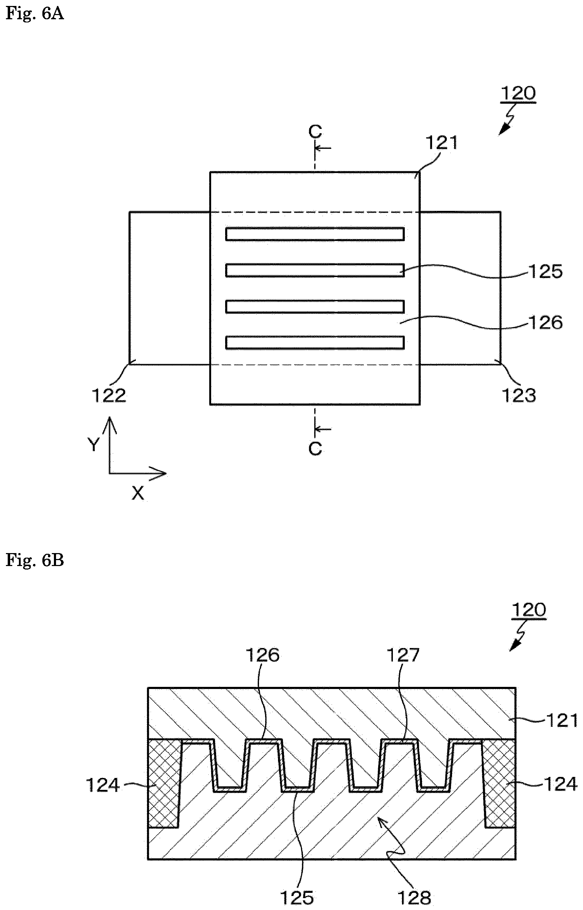

   Fig. 6A is a plan view of a trench transistor according to Example 1, and Fig. 6B is a cross-sectional view taken along line C-C of Fig. 6A.
[Fig. 7]

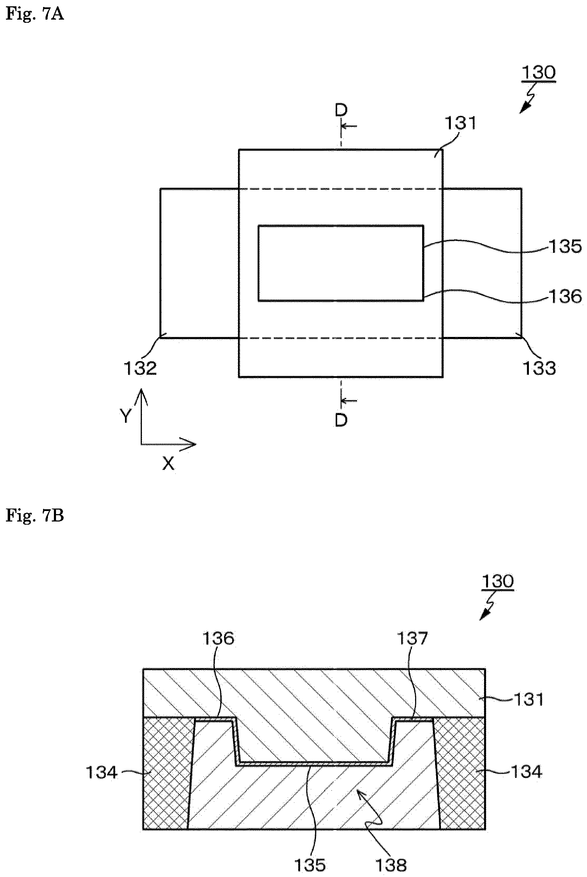

   Fig. 7A is a plan view of a trench transistor according to Example 2, and Fig. 7B is a cross-sectional view taken along line D-D of Fig. 7A.
[Fig. 8]

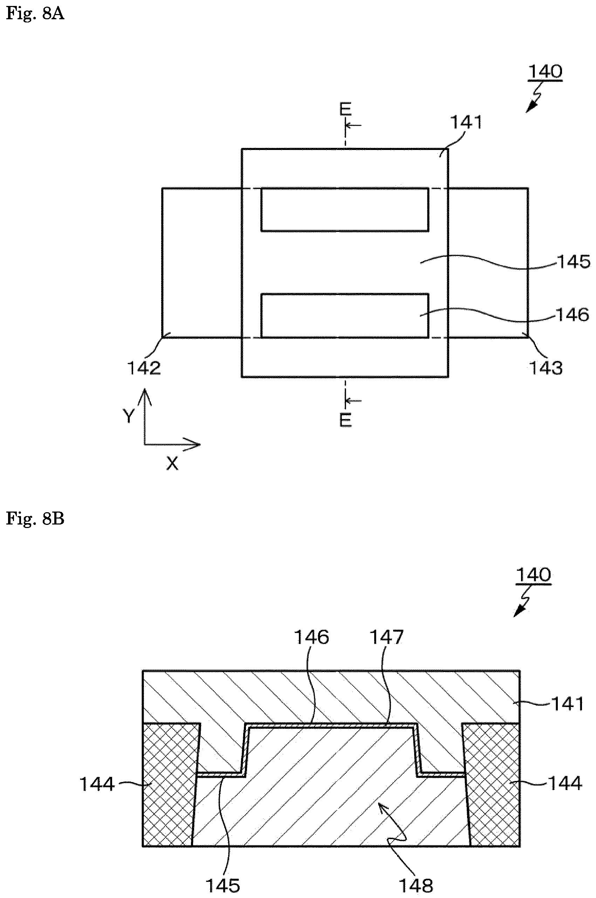

   Fig. 8A is a plan view of a trench transistor according to Example 3, and Fig. 8B is a cross-sectional view taken along line E-E of Fig. 8A.
[Fig. 9]

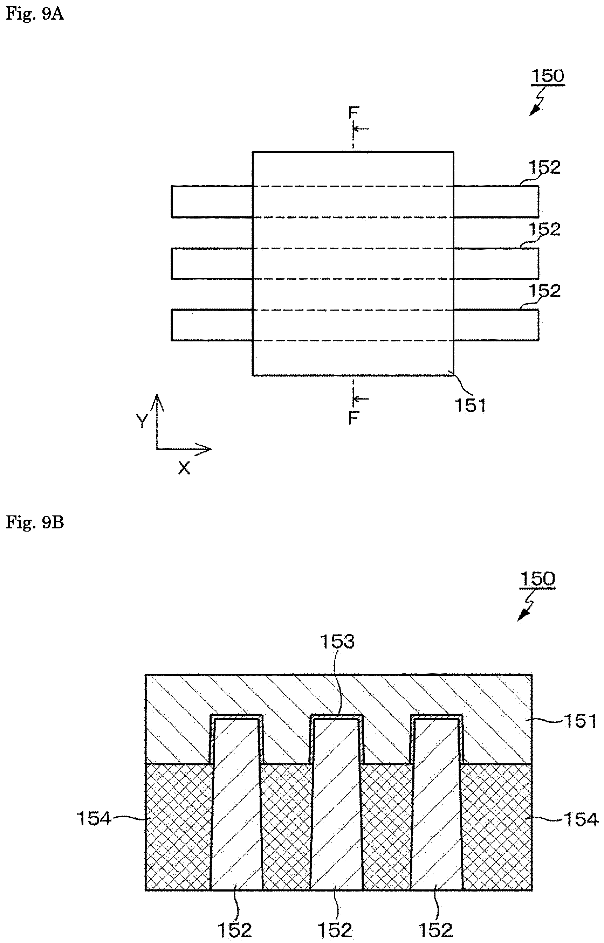

   Fig. 9A is a plan view of a FIN transistor according to Example 4, and Fig. 9B is a cross-sectional view taken along line F-F of Fig. 9A.
[Fig. 10]

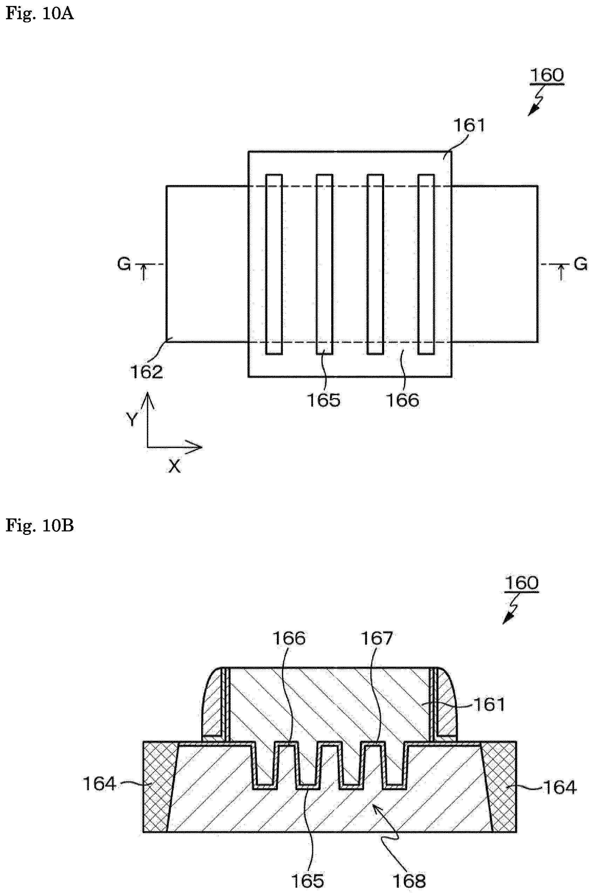

   Fig. 10A is a plan view of a trench transistor according to Example 5, and Fig. 10B is a cross-sectional view taken along line G-G of Fig. 10A.
[Fig. 11]

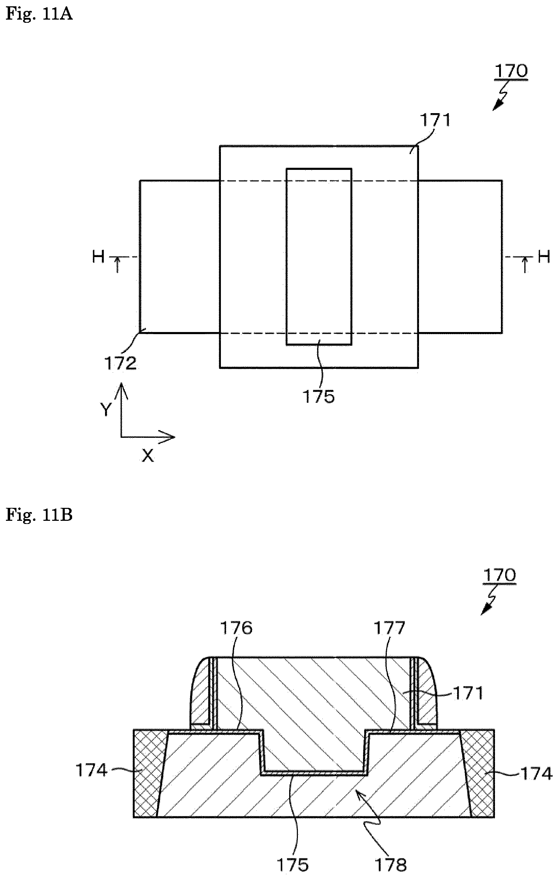

   Fig. 11A is a plan view of a trench transistor according to Example 6, and Fig. 11B is a cross-sectional view taken along line H-H of Fig. 11A.
[Fig. 12]

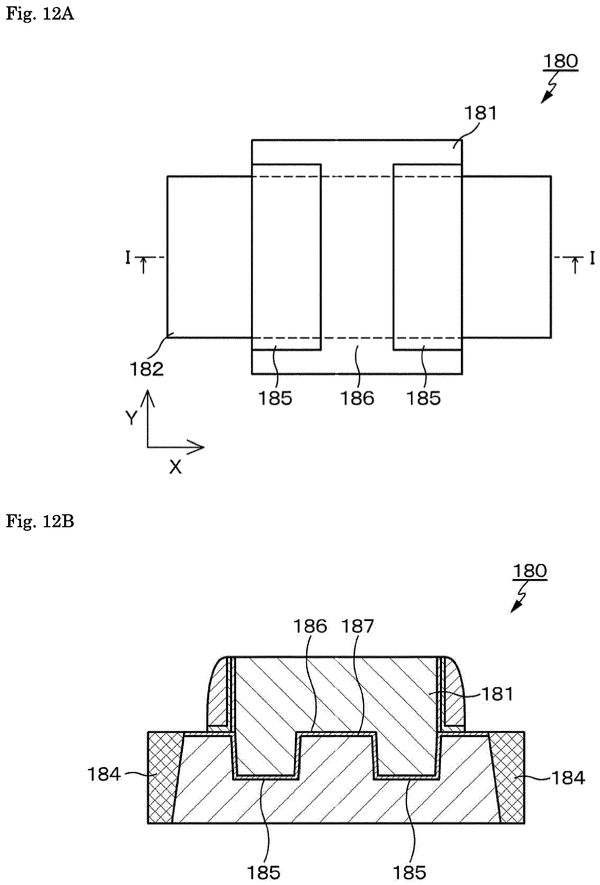

   Fig. 12A is a plan view of a trench transistor according to Example 7, and Fig. 12B is a cross-sectional view taken along line I-I of Fig. 12A.
[Fig. 13]

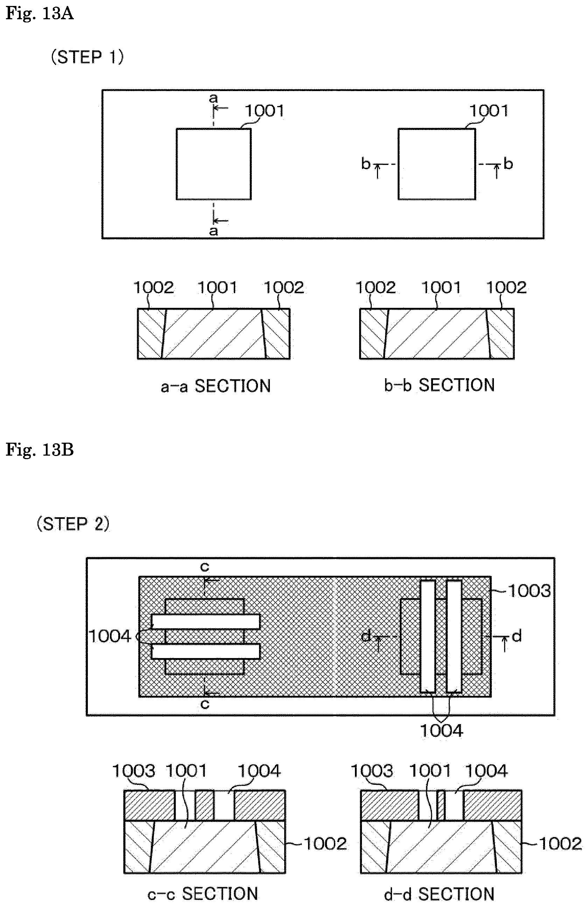

   Figs. 13A and 13B are process drawings (1) illustrating a method of forming a trench transistor according to Example 8.
[Fig. 14]

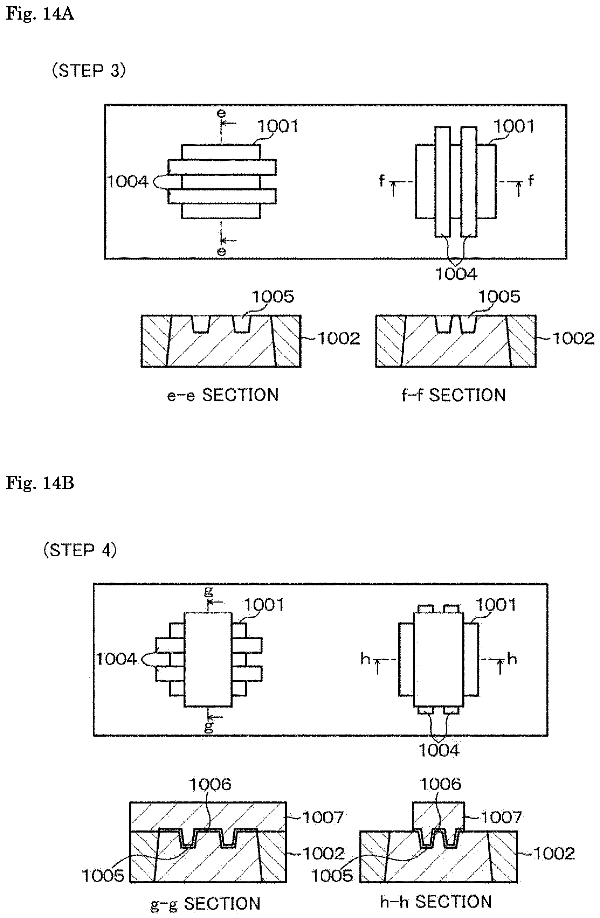

   Figs. 14A and 14B are process drawings (2) illustrating the method of forming the trench transistor according to Example 8.
[Fig. 15]

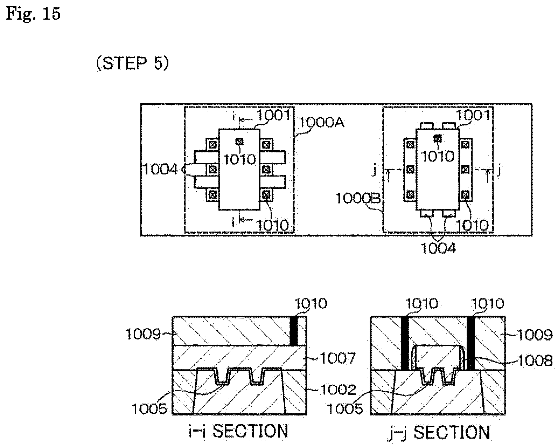

   Fig. 15 is a process drawing (3) illustrating the method of forming the trench transistor according to Example 8.
[Fig. 16]

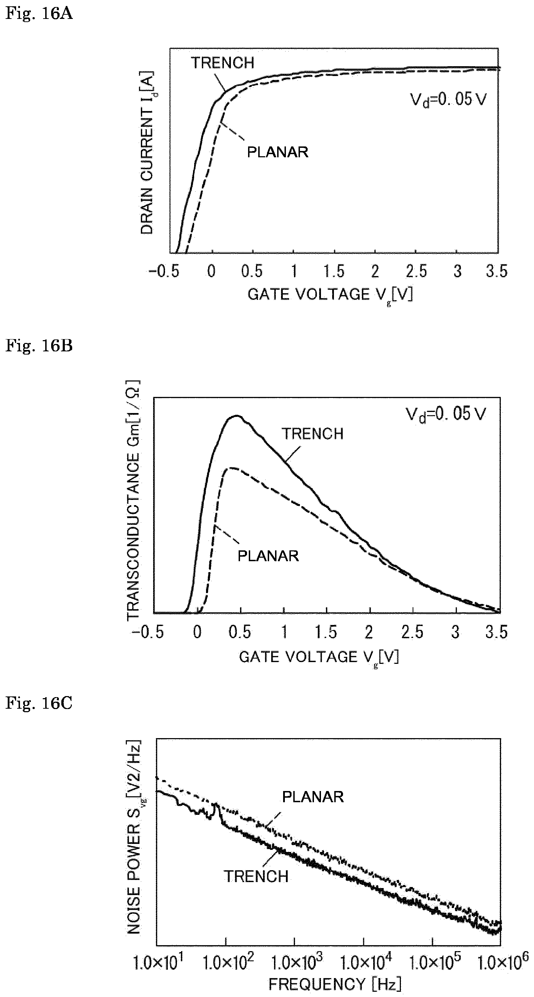

   Figs. 16A, 16B, and 16C are characteristic diagrams for comparing the effects of a trench transistor with those of a planar transistor.
[Fig. 17]

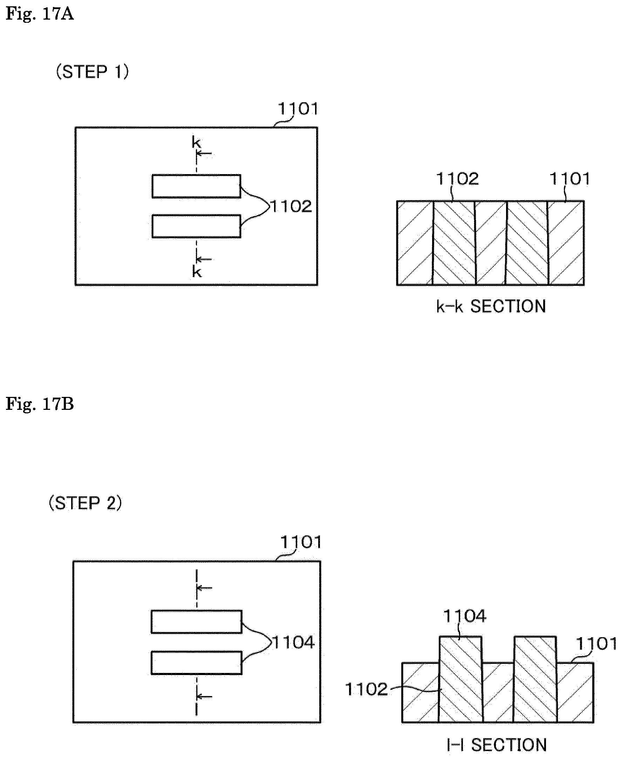

   Figs. 17A and 17B are process drawings (1) illustrating a method of forming a FIN transistor according to Example 9.
[Fig. 18]

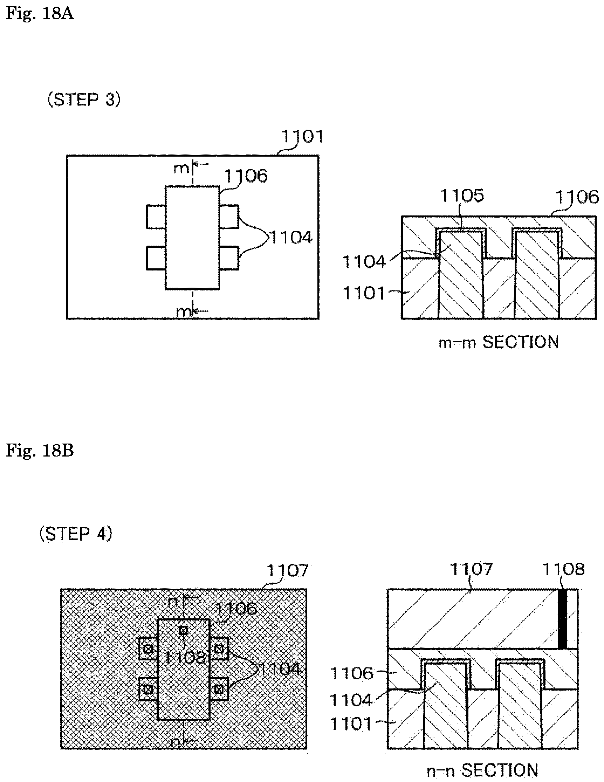

   Figs. 18A and 18B are process drawings (2) illustrating the method of forming the FIN transistor according to Example 9.
[Fig. 19]

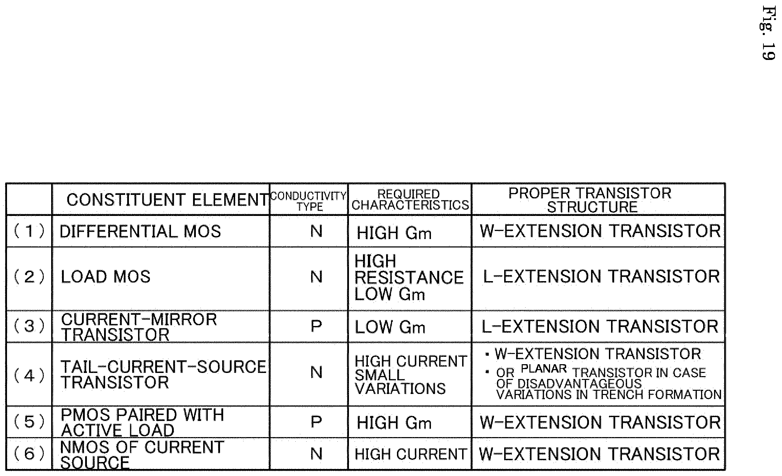

   Fig. 19 is a diagram showing a list of application examples of W-extension/L-extension transistors.
[Fig. 20]

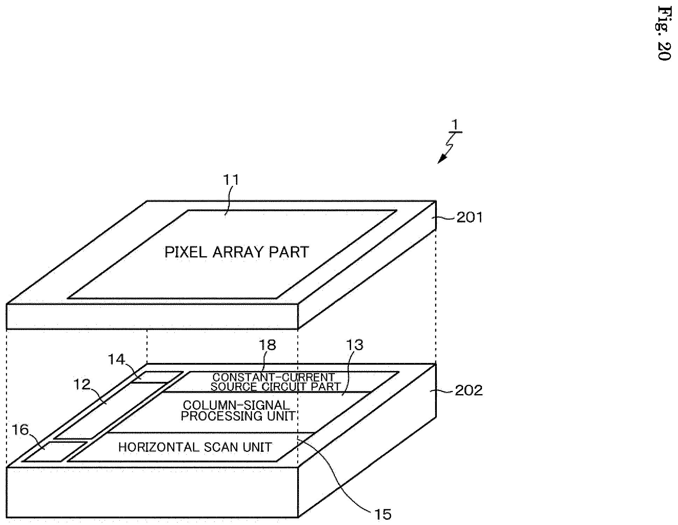

   Fig. 20 is an exploded perspective view illustrating the laminated chip structure of an imaging device.
[Fig. 21]

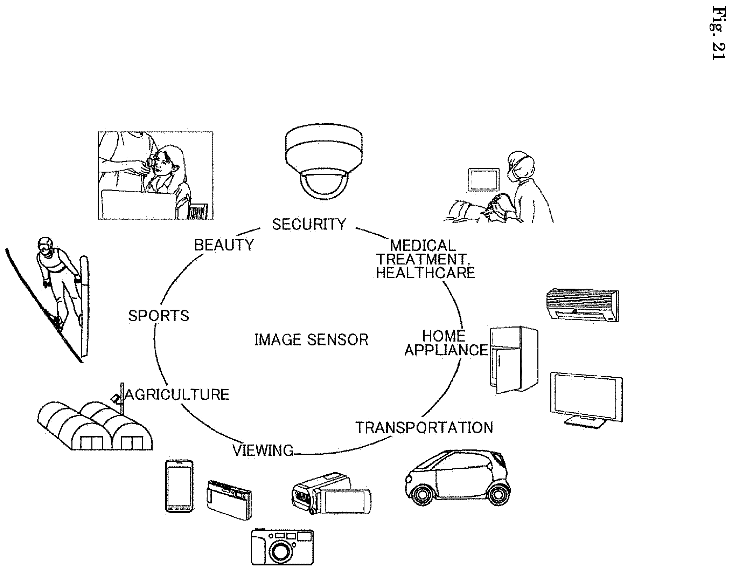

   Fig. 21 is a diagram illustrating application examples of a technique according to the present disclosure.
[Fig. 22]

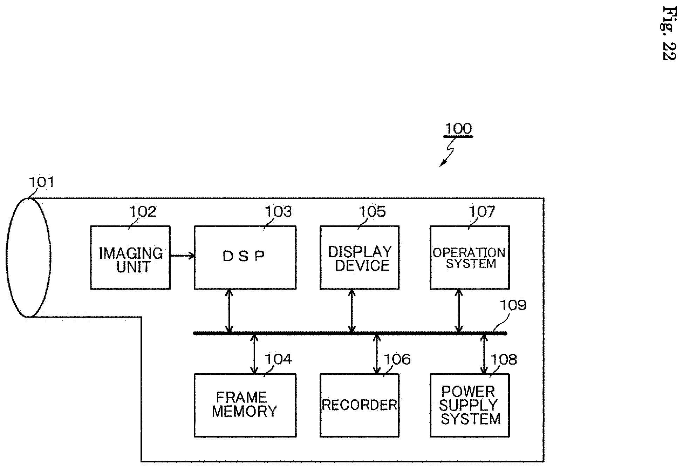

   Fig. 22 is a block diagram schematically illustrating a configuration example of an imaging system that is an example of an electronic device of the present disclosure.
[Fig. 23]

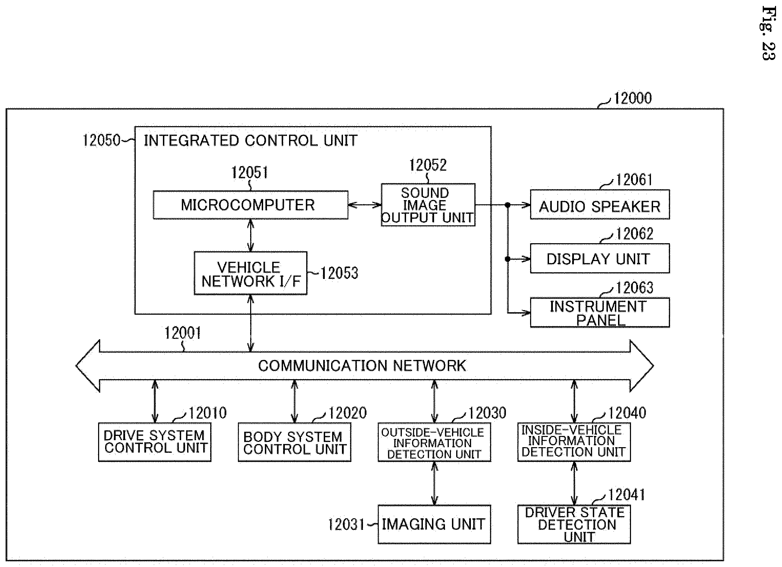

   Fig. 23 is a block diagram schematically illustrating a configuration example of a vehicle control system that is an example of a mobile-body control system to which the technique according to the present disclosure is applicable.
[Fig. 24]

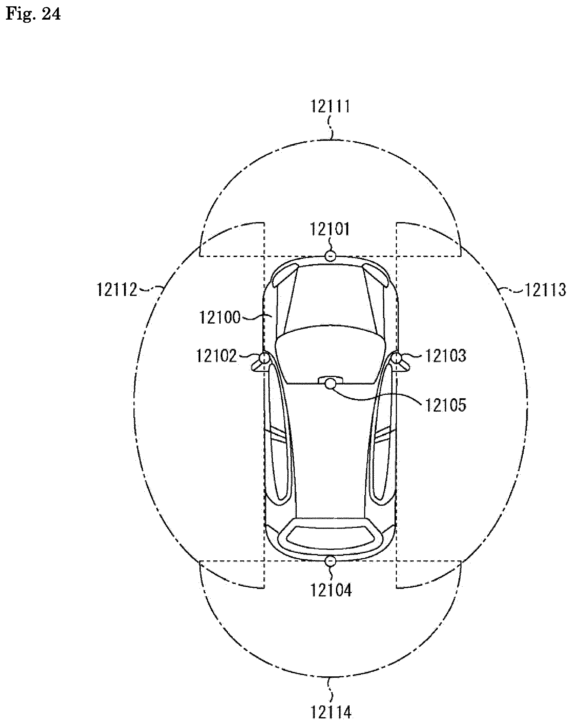

   Fig. 24 is a diagram illustrating an example of an installation position of an imaging unit in the mobile-body control system.

### [Description of Embodiments]

Hereinafter, modes for carrying out a technique according to the present disclosure (hereinafter referred to as "embodiments") will be specifically described below in accordance with the accompanying drawings. The technique according to the present disclosure is not limited to the embodiments, and various numerical values and materials in the embodiments are exemplary. In the following description, the same reference signs will be used for the same elements or the elements having the same function, and redundant descriptions are omitted. The description will be given in the following order.
1. Overall description of imaging device and electronic device according to present disclosure
2. Imaging device to which technique according to present disclosure is applied
   2-1. System configuration example
   2-2. Pixel configuration example
   2-3. Chip structure
   2-4. Configuration example of analog-digital conversion unit
   2-5. Circuit example of comparator
   2-6. MOS transistor constituting comparator
3. Imaging device according to first embodiment (example applied to transistor constituting comparator)
   3-1. Example 1 (example of trench transistor with extended channel width)
   3-2. Example 2 (modification of Example 1: example of three-dimensional structure including single recessed portion)
   3-3. Example 3 (modification of Example 1: example of three-dimensional structure including single projecting portion)
   3-4. Example 4 (example of FIN transistor)
4. Imaging device according to second embodiment (example applied to transistor constituting constant-current source)
   4-1. Example 5 (example of trench transistor with extended channel length)
   4-2. Example 6 (modification of Example 5: example of three-dimensional structure including single recessed portion)
   4-3. Example 7 (modification of Example 5: example of three-dimensional structure including single projecting portion)
   4-4. Example 8 (example of method of forming trench transistor)
   4-5. Example 9 (example of method of forming FIN transistor)
5. Summary of first embodiment and second embodiment
   5-1. Application examples of W-extension/L-extension transistors
   5-2. Chip structure of imaging device
6. Modification
7. Application examples
8. Application example of technique according to present disclosure
   8-1. Electronic device according to present disclosure (example of imaging device)
   8-2. Example of application to mobile body
9. Configurations adoptable by present disclosure

### <Overall description of an imaging device and an electronic device according to the present disclosure>

A first imaging device and a first electronic device according to the present disclosure are configured such that a comparator includes a differential transistor and a current mirror circuit while a transistor constituting a differential circuit has a three-dimensional structure including a channel parallel to the direction of a current flow. Moreover, the transistor constituting the differential circuit includes a trench transistor and one or more recessed portions.

Moreover, the first imaging device and the first electronic device that include the preferable configuration according to the present disclosure are configured such that the comparator includes a differential transistor and a current mirror circuit while a transistor constituting the current mirror circuit has a three-dimensional structure including a channel perpendicular to the direction of a current flow. Moreover, the transistor constituting the current mirror circuit includes a trench transistor.

The first imaging device and the first electronic device that include the preferable configuration according to the present disclosure may be provided with a constant-current source circuit part having a constant-current source connected to a vertical signal line provided for the column array of a pixel array part. Furthermore, a transistor constituting the constant-current source may have a three-dimensional structure including a channel perpendicular to the direction of a current flow. Moreover, the transistor constituting the constant-current source may include a trench transistor.

### <Imaging device to which the technique according to the present disclosure is applied>

The basic system configuration of an imaging device to which the technique according to the present disclosure is applied (that is, an imaging device according to the present disclosure) will be first described below. Hereinafter, a CMOS(Complementary Metal Oxide Semiconductor) image sensor, which is a kind of imaging device of an X-Y addressing scheme, will be described as an example of the imaging device. The CMOS image sensor is an image sensor created by applying or partially using a CMOS process.

### [System configuration example]

Fig. 1 is a block diagram schematically illustrating the basic system configuration of a CMOS image sensor as an example of the imaging device according to the present disclosure.

An imaging device 1 according to the present example includes a pixel array part 11 and the peripheral circuit parts of the pixel array part 11. The pixel array part 11 includes pixels (pixel circuits) 2 that are arranged in the row direction and the column direction, that is, two-dimensionally in a matrix form, the pixel including a photoelectric conversion element. Here, the row direction is the arrangement direction (a so-called horizontal direction) of the pixels 2 in a pixel row, and the column direction is the arrangement direction (a so-called vertical direction) of the pixels 2 in a pixel column.

In the pixel array part 11, a pixel control line 31 (31₁ to 31ₘ) is wired for each pixel row along the row direction in the pixel array of the matrix form. Moreover, a vertical signal line 32 (32₁ to 32ₙ) is wired for each pixel column along the column direction. The pixel control line 31 transmits a driving signal for driving when a signal is read from each of the pixels 2 of the pixel array part 11. Note that, in Fig. 1, the pixel control line 31 is illustrated as a single wiring line, but the number of wiring lines is not limited thereto.

The constituent elements of the peripheral circuit part of the pixel array part 11 includes, for example, a vertical scan unit 12, a column-signal processing unit 13, a reference-signal generating unit 14, a horizontal scan unit 15, and a timing control unit 16. The functions of the vertical scan unit 12, the column-signal processing unit 13, the reference-signal generating unit 14, the horizontal scan unit 15, and the timing control unit 16 will be described below.

The vertical scan unit 12 includes, for example, a shift register or an address decoder and serves as a row selecting unit that selects the pixels 2 of the pixel array part 11 for each row. The vertical scan unit 12 controls a scan of a pixel row or the address of a pixel row. The vertical scan unit 12 typically includes two scanning systems, that is, a reading scan system and a sweeping scan system, though the specific configuration of the vertical scan unit 12 is not illustrated in the drawing.

The reading scan system sequentially selects and scans the pixels 2 of the pixel array part 11 for each row in order to read pixel signals from the pixels 2. The pixel signals read from the pixels 2 are analog signals. The sweeping scan system performs a sweeping scan on read rows, in which a reading scan is performed by the reading scan system, earlier than the reading scan by the time of a shutter speed.

Unnecessary charge is swept out from the photoelectric conversion elements of the pixels 2 of the read row by the sweeping scan performed by the sweeping scan system, and thus the photoelectric conversion elements are reset. By sweeping (resetting) the unnecessary charge by the sweeping scan system, a so-called electronic shutter operation is performed. Here, the electronic shutter operation is an operation of discarding the photogenerated charges of the photoelectric conversion elements and starting another exposure (starting the accumulation of the photogenerated charges).

The column-signal processing unit 13 includes analog-digital converters 50 (Fig. 3), each converting an analog pixel signal, which is outputted from each of the pixels 2 of the pixel array part 11, into a digital pixel signal. For example, the analog-digital converter 50 is disposed for each of the pixel columns of the pixel array part 11 and constitutes a column parallel analog-digital conversion unit. The analog-digital converter 50 can be, for example, a single-slope analog-digital converter, an example of an analog-digital converter of a reference-signal comparison type. The specific configuration of the analog-digital converter 50 will be described later.

The reference-signal generating unit 14 includes, for example, a digital-analog converter and generates a reference signal of a ramp(RAMP) wave with a level (voltage) monotonously decreasing with the passage of time. The reference signal generated by the reference-signal generating unit 14 is supplied to the analog-digital conversion unit 50 of the column-signal processing unit 13 and is used as a reference signal upon analog-digital conversion.

The horizontal scan unit 15 includes a shift register or an address decoder and controls a scan of the pixel row or the address of the pixel row when reading the signal of the pixel 2 of the pixel array part 11. Under the control of the horizontal scan unit 15, a pixel signal converted into a digital signal by the analog-digital conversion unit 50 of the column-signal processing unit 13 is outputted as an image signal through an output line 17.

The timing control unit 16 generates, for example, a timing signal, a clock signal, and a control signal of all kinds in response to, for example, a synchronizing signal V_{SYNC} supplied from the outside, and controls the driving of the vertical scan unit 12, the column-signal processing unit 13, the reference-signal generating unit 14, and the horizontal scan unit 15 in response to the generated signals.

The imaging device 1 of the present example includes a constant-current source circuit part 18 in addition to the vertical scan unit 12, the column-signal processing unit 13, the reference-signal generating unit 14, the horizontal scan unit 15, and the timing control unit 16.

As illustrated in Fig. 2, the constant-current source circuit part 18 basically includes a set of constant-current sources 181, each being connected to the vertical signal line 32 for each pixel column. A bias current is supplied through the vertical signal lines 32 to the pixels 2 of the pixel rows selected and scanned by the vertical scan unit 12.

The constant-current source 181 is configured by using, for example, an N-channel MOS field effect transistor (FET) Tr_{_lm}. Hereinafter, the MOS field effect transistor constituting the constant-current source 181 may be abbreviated as a load MOS (Tr_{_lm}).

### [Circuit configuration example of pixel]

Fig. 2 is a circuit diagram illustrating an example of the circuit configuration of the pixel 2. The pixel 2 includes, for example, a photodiode 21 as a photoelectric conversion element (photoelectric conversion unit). The pixel 2 has a circuit configuration including a transfer transistor 22, a reset transistor 23, an amplification transistor 24, and a selection transistor 25 in addition to the photodiode 21.

The four transistors, that is, the transfer transistor 22, the reset transistor 23, the amplification transistor 24, and the selection transistor 25 are, for example, N-channel MOS field effect transistors (FETs). The combination of the conductivity types of the illustrated four transistors 22 to 25 is merely exemplary and is not limited thereto.

As the pixel control lines 31, pixel control lines are each wired in common to the pixels 2 in the same pixel row. The pixel control lines are connected, for each of the pixel rows, to output ends corresponding to the pixel rows of the vertical scan unit 12. The vertical scan unit 12 optionally outputs a transfer signal TRG, a reset signal RST, and a selection signal SEL to the pixel control lines.

The photodiode 21 with an anode electrode connected to a low-potential-side power supply (e.g., the ground) photoelectrically converts received light into a photocharge (here, photoelectrons) having a charge amount corresponding to the amount of the light, and accumulates the photocharge. The cathode electrode of the photodiode 21 is electrically connected to the gate electrode of the amplification transistor 24 via the transfer transistor 22.

In this configuration, a region to which the gate electrode of the amplification transistor 24 is electrically connected is a floating diffusion (floating diffusion region/impurity diffusion region) FD. The floating diffusion FD is a charge-voltage conversion unit that converts a charge into a voltage.

The gate electrode of the transfer transistor 22 receives the transfer signal TRG, which becomes active at a high level (e.g., a V_{DD} level), from the vertical scan unit 12. The transfer transistor 22 is brought into conduction in response to the transfer signal TRG, so that photoelectric conversion is performed in the photodiode 21 and photocharge accumulated in the photodiode 21 is transferred to the floating diffusion FD.

The reset transistor 23 is connected between the node of a high-potential-side power supply voltage V_{DD} and the floating diffusion FD. The gate electrode of the reset transistor 23 receives the reset signal RST, which becomes active at a high level, from the vertical scan unit 12. The reset transistor 23 is brought into conduction in response to the reset signal RST and discards the charge of the floating diffusion FD into the power supply line of the power supply voltage V_{DD}, thereby resetting the floating diffusion FD.

The amplification transistor 24 has the gate electrode connected to the floating diffusion FD and the drain electrode connected to the power supply line of the power supply voltage V_{DD}. The amplification transistor 24 serves as an input unit for a source follower for reading a signal obtained by photoelectric conversion in the photodiode 21. In other words, the amplification transistor 24 has the source electrode connected to the vertical signal line 32 via the selection transistor 25.

The amplification transistor 24 and the load MOSTr_{_lm} constituting the constant-current source 181 connected to the vertical signal line 32 constitute a source follower for converting the voltage of the floating diffusion FD into the potential of the vertical signal line 32. The load MOSTr_{_lm} constituting the constant-current source 181 supplies a bias current through the vertical signal line 32 to the pixels 2 of the pixel rows selected scanned by the vertical scan unit 12.

The selection transistor 25 has the drain electrode connected to the source electrode of the amplification transistor 24 and the source electrode connected to the vertical signal line 32. The gate electrode of the selection transistor 25 receives the selection signal SEL, which becomes active at a high level, from the vertical scan unit 12. The selection transistor 25 is brought into conduction in response to the selection signal SEL, so that the pixel 2 is placed into a selected state and the pixel signal passing through the amplification transistor 24 is outputted to the vertical signal line 32.

The circuit example of the pixel 2 illustrated a 4Tr configuration including the transfer transistor 22, the reset transistor 23, the amplification transistor 24, and the selection transistor 25, that is, four transistors (Tr). The circuit configuration is not limited thereto. For example, a 3Tr configuration may be used such that the selection transistor 25 is omitted and the amplification transistor 24 has the function of the selection transistor 25. Moreover, a 5Tr or larger configuration may be used as needed with a larger number of transistors.

### [Configuration example of analog-digital conversion unit]

A configuration example of the column parallel analog-digital conversion unit constituting the column-signal processing unit 13 will be described below. Fig. 3 illustrates a configuration example of the column parallel analog-digital conversion unit.

The column parallel analog-digital conversion unit constituting the column-signal processing unit 13 includes a plurality of analog-digital converters provided for the respective pixel columns of the pixel array part 11, more specifically, a set of single-slope analog-digital converters. In this example, the single-slope analog-digital converter 50 provided for the n-th pixel column will be described.

The single-slope analog-digital converter 50 has a circuit configuration including a comparator 51, a counter circuit 52, and a latch circuit 53. In the single-slope analog-digital converter 50, a reference signal V_{ref} of a ramp wave is used, the reference signal being generated by the reference-signal generating unit 14. Specifically, the reference signal V_{ref} of a ramp wave is supplied as a reference signal to the comparator 51 provided for each pixel column.

The comparator 51 compares an analog pixel signal V_{sig} read as a comparison input from the pixel 2 and the reference signal V_{ref} of a ramp wave as a reference input, the reference signal being generated by the reference-signal generating unit 14. The comparator 51 is placed into a first state (e.g., a high level) when the reference signal V_{ref} is larger than the pixel signal V_{sig}, and is placed into a second state (e.g., a low level) when the reference signal V_{ref} is not larger than the pixel signal V_{sig}. Thus, the comparator 51 outputs, as a comparison result, a pulse signal having a pulse width corresponding to the signal level of the pixel signal, specifically, the height of the signal level.

The counter circuit 52 receives a clock signal CLK from the timing control unit 16 at the same timing as the start of supply of the reference signal V_{ref} to the comparator 51. The counter circuit 52 then performs counting in synchronization with the clock signal CLK, thereby measuring the period of the pulse width of an output pulse from the comparator 51, that is, a period from the start to the end of a comparing operation. The counting result (count value) of the counter circuit 52 serves as the digital value of the analog pixel signal V_{sig}.

The latch circuit 53 holds(latches) the digital value that is the counting result of the counter circuit 52. Moreover, the latch circuit 53 performs CDS(Correlated Double Sampling), which is an example of noise reduction, by obtaining a difference a count value corresponding to the pixel signal (a so-called D phase) at a data level and a count value corresponding to a pixel signa (a so-called P phase) at a reset level. The latch circuit 53 then outputs the latched digital value to the output line 17 while being driven by the horizontal scan unit 15.

As described above, in the column parallel analog-digital conversion unit including the set of the single-slope analog-digital converters 50, a digital value is obtained from time information until the magnitude relationship changes between the analog reference signal V_{ref}, which is generated by the reference-signal generating unit 14 and linearly changes, and the analog pixel signal V_{sig} outputted from the pixel 2.

In the foregoing example, the analog-digital converter 50 is disposed for each pixel column as the column parallel analog-digital conversion unit. The analog-digital converter 50 may be disposed for a plurality of pixel columns.

### [Circuit example of comparator]

A circuit example of the comparator 51 constituting the single-slope analog-digital converter 50 will be described below. Fig. 4 illustrates an example of the circuit configuration of the comparator 51.

As illustrated in Fig. 4, the comparator 51 constituting the single-slope analog-digital converter 50 includes a first amplifier unit 511 serving as a differential stage, a second amplifier unit 512 serving as a source ground stage, and an output unit 513.

The first amplifier unit 511 includes a first differential transistor NT₁₁, a second differential transistor NT₁₂, a tail-current-source transistor NT₁₃, a first capacitive element C₁₁, a second capacitive element C₁₂, a first current-mirror transistor PT₁₁, and a second current-mirror transistor PT₁₂.

In this configuration, the first differential transistor NT₁₁, the second differential transistor NT₁₂, and the tail-current-source transistor NT₁₃ are N-channel MOS field effect transistors (hereinafter referred to as "MOS transistors") while the first current-mirror transistor PT₁₁ and the second current-mirror transistor PT₁₂ are P-channel MOS transistors.

The first differential transistor NT₁₁ and the second differential transistor NT₁₂ with the source electrodes making a common connection constitute a differential circuit for performing a differential operation. The gate electrode of the first differential transistor NT₁₁ receives the analog reference signal V_{ref} via the first capacitive element C₁₁, and the gate electrode of the second differential transistor NT₁₂ receives the analog pixel signal V_{sig} via the second capacitive element C₁₂.

The tail-current-source transistor NT₁₃ is connected between the source common connection node of the first differential transistor NT₁₁ and the second differential transistor NT₁₂ and the power supply line of a low-potential-side power supply voltage Vss.

The first current-mirror transistor PT₁₁ is diode-connected with the gate electrode and the drain electrode making a common connection and is connected in series with the first differential transistor NT₁₁. In other words, the drain electrodes of the first current-mirror transistor PT₁₁ and the first differential transistor NT₁₁ make a common connection.

The second current-mirror transistor PT₁₂ is connected in series with the second differential transistor NT₁₂. In other words, the drain electrodes of the second current-mirror transistor PT₁₂ and the second differential transistor NT₁₂ make a common connection.

The first current-mirror transistor PT₁₁ and the second current-mirror transistor PT₁₂ with the gate electrodes making a common connection constitute a current mirror circuit. The source electrodes of the first current-mirror transistor PT₁₁ and the second current-mirror transistor PT₁₂ are connected to the power supply line of a high-potential-side power supply voltage VDD.

In the first amplifier unit 511 serving as a differential stage of the configuration, the common connection node of the second differential transistor NT₁₂ and the second current-mirror transistor PT₁₂ serves as an output node N₁₁ of the first amplifier unit 511.

The second amplifier unit 512 serving as a source ground stage includes a P-channel MOS transistor PT₁₃, an N-channel MOS transistor NT₁₄, a capacitive element C₁₃, and an N-channel switch transistor NT₄₂. The P-channel MOS transistor PT₁₃ is a twin transistor of the active load of the current mirror circuit. The N-channel MOS transistor NT₁₄ is a current source transistor.

In the second amplifier unit 512, the P-channel MOS transistor PT₁₃ has the gate electrode connected to the output node N₁₁ of the first amplifier unit 511 and the source electrode connected to the power supply line of the high-potential-side power supply voltage V_{DD}. The N-channel MOS transistor NT₁₄ has the drain electrode connected to the drain electrode of the P-channel MOS transistor PT₁₃ and the source electrode connected to the power supply line of the low-potential-side power supply voltage Vss. The capacitive element C₁₃ is connected between the gate electrode of the N-channel MOS transistor NT₁₄ and the power supply line of the low-potential-side power supply voltage Vss.

In the second amplifier unit 512 serving as the source ground stage of the configuration, the common connection node of the drain electrode of the P-channel MOS transistor PT₁₃ and the drain electrode of the N-channel MOS transistor NT₁₄ serves as an output node N₁₂ of the second amplifier unit 512.

The output unit 513 includes, for example, a 2-input NAND circuit 514. The NAND circuit 514 is connected between the power supply line of the high-potential-side power supply voltage V_{DD} and the power supply line of the low-potential-side power supply voltage Vss. One input end of the NAND circuit 514 is connected to the output node N₁₂ of the second amplifier unit 512. The other input end of the NAND circuit 514 receives a control signal V_{COEN}. The output of the NAND circuit 514 serves as the comparison output of the comparator 51.

### [MOS transistor constituting a comparator]

Imaging devices, typified by a CMOS image sensor, are mounted and used in, for example, imaging systems such as a digital still camera and a video camera or portable terminals such as a smartphone and a tablet. Thus, a smaller chip size is particularly required for imaging devices.

In the imaging device 1 including the analog-digital converter 50, the analog-digital converter 50 is provided for the corresponding pixel column (for example, for each pixel column) of the pixel array part 11. The number of analog-digital converters 50 is equivalent to the number of horizontal pixels. Thus, a smaller chip size can be obtained by downsizing the analog-digital converter 50.

The analog-digital converter 50 includes the comparator 51. The analog-digital converter 50 can be downsized by shrinking the device area of the transistor constituting the comparator 51, leading to a smaller chip size. Conventionally, planar transistors have been used as transistors constituting the comparator 51. However, a shrinkage in the device area of the differential transistor (NT₁₁, NT₁₂) including a planar transistor may increase random noise.

A planar transistor will be described below. Fig. 5A illustrates a plan view of a planar transistor. Fig. 5B illustrates a cross-sectional view taken along line A-A of Fig. 5A, and Fig. 5C illustrates a cross-sectional view taken along line B-B of Fig. 5A.

A planar transistor 110 includes semiconductor regions (source/drain regions) 112, 113 provided for a gate electrode 111, is surrounded by an element isolation region 114 acting as an insulator, and has a part 116 serving as a channel forming region in contact with a gate oxide film 115.

### <Imaging device according to first embodiment>

The imaging device 1 according to a first embodiment includes the pixel array part 11, in which the pixels 2 are disposed, and the analog-digital converters 50. The pixel 2 includes the photodiode 21, and the analog-digital converter 50 converts an analog signal, which is outputted from each of the pixels 2 of the pixel array part 11, into a digital signal. The analog-digital converter 50 further includes the comparator 51. The transistor constituting the comparator 51 has a three-dimensional structure including a channel parallel to or perpendicular to the direction of a current flow (that is, a channel length direction).

In this configuration, "transistor" means a device that is a kind of FET (field effect transistor) acting as a semiconductor device, has a MIS (Metal-Insulator-Semiconductor) structure, has a source region and a drain region on a semiconductor substrate, and passes a current between the source region and the drain region through the channel in response to a voltage applied to the gate electrode and the source electrode or the drain electrode. A distance between the source region and the drain region is a channel length (L), and a length in the depth direction is a channel width (W).

In the first embodiment, the device area of the transistor constituting the comparator 51 is shrunk to reduce the chip size of the imaging device 1. The transistor constituting the comparator 51 is typified by a differential transistor constituting a differential circuit (hereinafter may be abbreviated as "differential MOS") and a transistor constituting a current mirror circuit (hereinafter may be abbreviated as "current-mirror transistor").

A shrinkage in the device area of the differential MOS (NT₁₁, NT₁₂) increases random noise. Thus, in order to reduce random noise in the first embodiment, the differential MOS (NT₁₁, NT₁₂) is provided as a transistor having a three-dimensional structure including a channel parallel to the direction of a current flow, that is, along the channel length direction. The three-dimensional structure can increase an effective channel width, thereby shrinking the device area while reducing random noise.

The transistor having a three-dimensional structure is a trench transistor.

In the following specific examples, the transistor constituting the comparator 51 is a transistor having a three-dimensional structure including a channel parallel to or perpendicular to the direction of a current flow.

### [Example 1]

Example 1 is an example describing a trench transistor that includes a channel parallel to the direction of a current flow and extends the channel width (W), as a differential MOS constituting the differential circuit of the comparator 51.

With the three-dimensional structure including a channel parallel to the direction of a current flow, that is, along the channel length direction, the channel width (W) can be extended via the sides of a portion recessed inward. The extension of the channel width (W) increases a transconductance Gm(1/Q) greater than the planar transistor 110. The transconductance Gm is an index indicating the capability of an FET. The larger the value of the transconductance Gm, the higher the current driving capability.

Thus, the extension of the channel width (W) increases the transconductance Gm and reduces the resistance of the transistor, thereby reducing random noise. The W-extension transistor is applied to the differential MOS (NT₁₁, NT₁₂) constituting the differential circuit that is an example of a constituent element of the comparator 51 serving as a peripheral circuit of the pixel array part 11, achieving a remarkable noise reduction effect as compared with the application of the planar transistor 110.

Fig. 6A illustrates a plan view of the trench transistor according to Example 1, and Fig. 6B illustrates a cross-sectional view taken along line C-C of Fig. 6A.

A trench transistor 120 according to Example 1 includes semiconductor regions (source/drain regions) 122, 123 provided for a gate electrode 121 and has element isolation regions 124 acting as insulators on both sides of a direction Y perpendicular to a direction X of a current flow. Moreover, channels are formed in parallel with the direction X of a current flow, that is, along the channel length direction.

The channels are formed thus, so that the trench transistor 120 according to Example 1 has a three-dimensional structure in which a plurality of recessed portions 125 and a plurality of projecting portions 126 are alternately placed in the direction Y (that is, the channel width direction) perpendicular to the direction X (that is, the channel length direction) of a current flow. The three-dimensional structure forms the channels such that current passes through all of a top surface, sides, and undersurfaces including the plurality of recessed portions 125 and the plurality of projecting portions 126. Apart in contact with a gate oxide film 127 serves as a channel forming region 128.

The trench transistor 120 according to Example 1 has a three-dimensional structure in which the plurality of recessed portions 125 and the plurality of projecting portions 126 are alternately placed in the direction Y perpendicular to the direction X of a current flow. This achieves a larger effective channel area than the planar transistor 110 having the same area as illustrated in Figs. 5A, 5B, and 5C. Moreover, the channel width is extended via the sides of the plurality of recessed portions 125 and the plurality of projecting portions 126 in the channel width direction (Y direction).

### [Example 2]

Example 2 is a modification of Example 1, that is, an example of a three-dimensional structure including a single recessed portion. The three-dimensional structure of the trench transistor according to Example 1 includes the plurality of recessed portions 125 and the plurality of projecting portions 126. The three-dimensional structure of a trench transistor according to Example 2 includes a single recessed portion.

Fig. 7A illustrates a plan view of the trench transistor according to Example 2, and Fig. 7B illustrates a cross-sectional view taken along line D-D of Fig. 7A.

Like the trench transistor 120 according to Example 1, a trench transistor 130 according to Example 2 includes semiconductor regions (source/drain regions) 132, 133 provided for a gate electrode 131 and has element isolation regions 134 acting as insulators on both sides of a direction Y perpendicular to a direction X of a current flow.

The trench transistor 130 according to Example 2 has a three-dimensional structure in which a recessed portion 135 is formed like a channel in parallel with the direction X of a current flow, that is, along the channel length direction at a portion corresponding to the central portion of the gate electrode 131, and projecting portions 136 are formed on both sides of the recessed portion 135 in the direction Y perpendicular to the direction X of a current flow. The three-dimensional structure forms the channel such that current passes through all of a top surface, sides, and an undersurface including the single recessed portion 135 and the projecting portions 136 on both sides of the recessed portion 135. A part in contact with a gate oxide film 137 serves as a channel forming region 138.

Also in the trench transistor 130 having the three-dimensional structure including the single recessed portion 135 according to Example 2, a channel width (W) can be extended via the sides of the recessed portion 135 in the channel width direction (Y direction). Thus, the same operation and effect as the trench transistor 120 according to Example 1, that is, an application to the differential MOS (NT₁₁, NT₁₂) can achieve a remarkable noise reduction effect.

### [Example 3]

Example 3 is a modification of Example 1, that is, an example of a three-dimensional structure including a single projecting portion. The three-dimensional structure of the trench transistor according to Example 1 includes the plurality of recessed portions 125 and the plurality of projecting portions 126. The three-dimensional structure of a trench transistor according to Example 3 includes a single projecting portion.

Fig. 8A illustrates a plan view of the trench transistor according to Example 3, and Fig. 8B illustrates a cross-sectional view taken along line E-E of Fig. 8A.

Like the trench transistor 120 according to Example 1, a trench transistor 140 according to Example 3 includes semiconductor regions (source/drain regions) 142, 143 provided for a gate electrode 141 and has element isolation regions 144 acting as insulators on both sides of a direction Y perpendicular to a direction X of a current flow.

The trench transistor 140 according to Example 3 has a three-dimensional structure in which a projecting portion 146 is formed at a portion corresponding to the central portion of the gate electrode 141, and recessed portions 145 are formed like channels on both sides of the projecting portion 146 in the direction Y perpendicular or the direction X of a current flow so as to extend in parallel with the direction X of a current flow, that is, along the channel length direction. The three-dimensional structure forms the channel such that current passes through all of a top surface, sides, and undersurfaces including the single projecting portion 146 and the recessed portions 145 on both sides of the projecting portion 146. Apart in contact with a gate oxide film 147 serves as a channel forming region 148.

Also in the trench transistor 140 having the three-dimensional structure including the single projecting portion 146 according to Example 3, a channel width (W) can be extended via the sides of the recessed portions 145 and the projecting portion 146 in the channel width direction (Y direction). Thus, the same operation and effect as the trench transistor 120 according to Example 1, that is, an application to the differential MOS (NT₁₁, NT₁₂) can achieve a remarkable noise reduction effect.

### [Example 4]

Example 4 is an example, which is not according to the claimed invention, of a FIN transistor, that is, a channel-width (W) extension transistor. Fig. 9A illustrates a plan view of the FIN transistor according to Example 4, and Fig. 9B illustrates a cross-sectional view taken along line F-F of Fig. 9A.

A FIN transistor 150 according to Example 4 includes a plurality of FINs, for example, three FINs 152 provided for a gate electrode 151. The three FINs 152 are covered with gate oxide films 153 and the gate electrode 151 that form U shapes, and an element isolation region 154 acting as an insulator is provided under the gate electrode 151. In other words, the FIN transistor is different from the trench transistors according to Examples 1 to 3 in that the element isolation region 154 is provided at the bottom of the FIN transistor without forming any channels. In the FIN transistor 150, the FINs 152 are surrounded by the gate electrode 151 in three directions, facilitating the control of the potential of the channel portion by a gate voltage.

The trench transistors according to Examples 1 to 3 have a larger effective channel width for each plane area than the FIN transistor, advantageously increasing an on current. However, a large difference in current density between the top surface and the bottom causes current to preferentially pass through a part that is likely to carry current. This tends to increase a leak current or a subthreshold coefficient. Since the FIN transistor does not have a bottom channel, a threshold voltage Vₜₕ is more easily adjusted than in the trench transistor. The FIN transistor is advantageously used for a device susceptible to a leak current.

As a technique for adjusting the threshold voltage Vₜₕ, a metal gate may be formed by using a metal instead of polysilicon (Poly-Si) as a material of the gate electrode 151. The threshold voltage Vₜₕ can be controlled by selecting a material that is free of a depletion layer and has a proper work function. A material used instead of polysilicon for the gate electrode 151 may be a silicon compound, e.g., silicon nitride (SiN) or silicon carbide (SiC). A material of the metal gate, which is formed by using a metal, may be a metal, e.g., tungsten (W), hafnium (Hf), titanium (Ti), tantalum (Ta), or copper (Cu) or a compound of these metals and nitrogen (N), carbon (C), aluminum (Al), and silicon (Si).

The process of forming the metal gate is not illustrated. The metal gate can be formed by a typical gate-last process in which a gate stack is formed after a high-temperature process is performed on a source or a drain.

In ion implantation, the same ionic species is not implanted one time in the same step. Implantation is performed several times with multiple energy doses under different conditions, allowing implantation on the top surface and the bottom of the trench with proper energy doses. This can reduce unevenness in current density.

The FIN transistor 150 according to Example 4 has a structure in which the number of FINs 152 is three. The number of FINs 152 is not limited to three and may be one, two, or four or more.

In the first embodiment, the W-extension transistor with the three-dimensional channel width (W) was described as an example of the differential MOS (NT₁₁, NT₁₂) constituting the differential circuit. The three-dimensional technique is also applicable to other transistors constituting the comparator 51, for example, the current mirror transistors (PT₁₁, PT₁₂) constituting the current mirror circuit.

The current mirror transistor (PT₁₁, PT₁₂) that requires a high resistance value is preferably a transistor having a three-dimensional structure including a channel perpendicular to the direction of a current flow (that is, the channel length direction) instead of the channel width, that is, along the channel width direction. A specific example of the transistor is basically identical to a load mOSTr_{_lm} that constitutes the constant-current sources 181 as will be described in a second embodiment.

### <Imaging device according to second embodiment of present disclosure>

An imaging device 1 according to a second embodiment includes a pixel array part 11, in which pixels 2 are disposed, and a constant-current source circuit part 18. The pixel 2 includes a photodiode 21, and the constant-current source circuit part 18 includes constant-current sources 181, each being connected to a vertical signal line 32 provided for a column array of the pixel array part 11. The constant-current sources 181 includes a load MOSTr_{_lm}.

Examples 1 to 4 of the first embodiment described the W-extension transistor with the three-dimensional channel width (W). The W-extension transistor is provided to reduce the resistance of the differential MOS (NT₁₁, NT₁₂) constituting the differential circuit that is one of the constituent elements of the comparator 51 of the analog-digital converter 50. However, for the load MOS Tr_lm that is used as a resistance element and constitutes the constant-current sources 181, an extension of the effective channel width is not desirable because a resistance value may decrease.

Thus, in the second embodiment, a three-dimensional structure including a channel parallel to the direction of a current flow (that is, the channel length direction) is provided for the load MOS Tr_lm constituting the constant-current sources 181. In the following examples of the second embodiment, a three-dimensional structure including a channel parallel to the channel length direction is provided for the load MOS Tr_lm constituting the constant-current sources 181.

### [Example 5]

Example 5 is an example describing a trench transistor that includes a channel perpendicular to the direction of a current flow and extends a channel length (L), as a load MOS(Tr_{_lm}) constituting the constant-current source 181.

Fig. 10A illustrates a plan view of the trench transistor according to Example 5, and Fig. 10B illustrates a cross-sectional view taken along line G-G of Fig. 10A.

A trench transistor 160 according to Example 5 includes semiconductor regions (source/drain regions) 162, 163 provided for a gate electrode 161 and has element isolation regions 164 acting as insulators on both sides of a direction Y perpendicular to a direction X of a current flow. Moreover, channels are formed perpendicularly to the direction X of a current flow, that is, along the channel width direction.

The channels are formed thus, so that the trench transistor 160 according to Example 5 has a three-dimensional structure in which a plurality of recessed portions 165 and a plurality of projecting portions 166 are alternately placed in the direction X (that is, the channel length direction) of a current flow. The three-dimensional structure forms the channels such that current passes through all of a top surface, sides, and undersurfaces including the plurality of recessed portions 125 and the plurality of projecting portions 126. A part in contact with a gate oxide film 167 serves as a channel forming region 168.

In the trench transistor 160 having the three-dimensional structure including the plurality of recessed portions 165 according to Example 5, the channel length (L) can be extended via the sides of the plurality of recessed portions 165 in the channel length direction (X direction). The L-extension trench transistor 160 according to Example 5 is applied to the load MOS (Tr_{_lm}) constituting the constant-current source 181, thereby increasing a threshold voltage Vₜₕ, improving short-channel characteristics, and shrinking the layout as compared with a planar transistor having the same footprint (a size on a CAD).

Also in the L-extension trench transistor 160 according to Example 5, a metal gate is applied and a uniform profile is obtained in the depth direction by performing implantation several times, thereby reducing the depletion of a gate at the bottom of the trench and unevenness in current density on the surfaces of the trench as in a W-extension trench transistor.

### [Example 6]

Example 6 is a modification of Example 5, that is, an example of a three-dimensional structure including a single recessed portion. The three-dimensional structure of the trench transistor 160 according to Example 5 includes the plurality of recessed portions 165 and the plurality of projecting portions 166. The three-dimensional structure of a trench transistor according to Example 6 includes a single recessed portion.

Fig. 11A illustrates a plan view of the trench transistor according to Example 6, and Fig. 11B illustrates a cross-sectional view taken along line H-H of Fig. 11A.

Like the trench transistor 160 according to Example 5, a trench transistor 170 according to Example 6 includes semiconductor regions (source/drain regions) 172, 173 provided for a gate electrode 171 and has element isolation regions 174 acting as insulators on both sides of a direction Y perpendicular to a direction X of a current flow.

The trench transistor 170 according to Example 6 has a three-dimensional structure in which a recessed portion 175 is formed like a channel perpendicular to the direction X of a current flow, that is, along the channel width direction at a portion corresponding to the central portion of the gate electrode 171, and projecting portions 176 are formed on both sides of the recessed portion 175 in the direction X of a current flow. The three-dimensional structure forms the channel such that current passes through all of a top surface, sides, and an undersurface including the single recessed portion 175 and the projecting portions 176 on both sides of the recessed portion 175. Apart in contact with a gate oxide film 177 serves as a channel forming region 138.

Also in the trench transistor 170 having the three-dimensional structure including the single recessed portion 175 according to Example 6, a channel length (L) can be extended via the sides of the recessed portion 175 in the channel length direction (X direction). Thus, the same operation and effect as the trench transistor 160 according to Example 5, that is, an application to the load MOS (Tr_{_lm}) constituting the constant-current source 181 can increase a threshold voltage Vₜₕ, improve short-channel characteristics, and shrink the layout.

### [Example 7]

Example 7 is a modification of Example 5, that is, an example of a three-dimensional structure including a single projecting portion. The three-dimensional structure of the trench transistor 160 according to Example 5 includes the plurality of recessed portions 165 and the plurality of projecting portions 166. The three-dimensional structure of a trench transistor according to Example 7 includes a single projecting portion.

Fig. 12A illustrates a plan view of the trench transistor according to Example 7, and Fig. 12B illustrates a cross-sectional view taken along line I-I of Fig. 12A.

Like the trench transistor 160 according to Example 5, a trench transistor 180 according to Example 7 includes semiconductor regions (source/drain regions) 182, 183 provided for a gate electrode 181 and has element isolation regions 184 acting as insulators on both sides of a direction Y perpendicular to a direction X of a current flow.

The trench transistor 180 according to Example 7 has a three-dimensional structure in which a projecting portion 186 is formed at a portion corresponding to the central portion of the gate electrode 181, and recessed portions 185 are formed like channels on both sides of the projecting portion 186 the direction X of a current flow so as to extend perpendicularly to the direction X of a current flow, that is, along the channel width direction. The three-dimensional structure forms the channel such that current passes through all of a top surface, sides, and undersurfaces including the single projecting portion 186 and the recessed portions 185 on both sides of the projecting portion 186. A part in contact with a gate oxide film 187 serves as a channel forming region 188.

Also in the trench transistor 180 having the three-dimensional structure including the single projecting portion 186 according to Example 7, a channel length (L) can be extended via the sides of the recessed portion 185 and the projecting portion 186 in the channel length direction (X direction), achieving the same operation and effect as the trench transistor 160 according to Example 5.

### [Example 8]

Example 8 is an example of a method of forming (a method of manufacturing) a trench transistor that is a transistor having a three-dimensional structure. In this example, a W-extension transistor applied to a differential MOS (NT₁₁, NT₁₂) and an L-extension transistor applied to a load MOS (Tr_{_lm}) are formed at the same time. A method of forming main parts before the formation of contact electrodes will be described below. In this example, a three-dimensional structure having two recessed portions will be described. The number of recessed portions may be one or three or more.

Figs. 13A and 13B illustrate the process drawings (1) of a method of forming the trench transistor according to Example 8. Figs. 14A and 14B illustrate process drawings (2). Fig. 15 illustrates a process drawing (3). In the drawings of Figs. 13 to 15, the left transistor indicates a channel-width (W) extension transistor while the right transistor indicates a channel-length (L) extension transistor.

Step 1 in Fig. 13A illustrates a state where an element isolation region 1002 is formed in a semiconductor substrate 1001. In Fig. 13A, the a-a cross section is a cross-sectional view of the W-extension transistor, and the b-b section is a cross-sectional view of the L-extension transistor.

In step 2 of Fig. 13B, a trench pattern is patterned with a photoresist 1003. If the photoresist 1003 is a positive photoresist, the photoresist 1003 is not present and the semiconductor substrate 1001 is exposed in trench recessed portions 1004. In Fig. 13B, the c-c cross section is a cross-sectional view of the W-extension transistor, and the d-d section is a cross-sectional view of the L-extension transistor.

In step 3 of Fig. 14A, trenches 1005 are formed by a dry etching process, and then the photoresist 1003 is removed. In Fig. 14A, the e-e cross section is a cross-sectional view of the W-extension transistor, and the f-f section is a cross-sectional view of the L-extension transistor.

Subsequent to step 3, the step of implanting ions into the semiconductor substrate 1001 is performed, which is not illustrated, and then the step of forming a gate oxide film 1006 (Fig. 14B) is performed. The process then advances to step 4 illustrated in Fig. 14B.

In step 4 of Fig. 14B, for example, polysilicon as a gate material is deposited by a CVD process, a gate electrode 1007 is formed by a dry etching process, and then the photoresist is removed. In Fig. 14B, the g-g cross section is a cross-sectional view of the W-extension transistor, and the h-h section is a cross-sectional view of the L-extension transistor.

Subsequent to step 4, the step of implanting ions into the semiconductor substrate 1001 is performed, which is not illustrated, the step of forming side walls 1008 (Fig. 15) is performed, and then the step of silicidation is performed. The process then advances to step 5 illustrated in Fig. 15.

In step 5 of Fig. 15, an interlayer film 1009 is formed, contact electrodes 1010 are typically formed by lithography and a dry etching process, and then the photoresist is removed. The interlayer film 1009 is, for example, a laminate of silicon nitride (SiN) and silicon dioxide (SiO2).

In Fig. 15, the left transistor is a W-extension transistor 1000A while the right transistor is an L-extension transistor 1000B. The i-i cross section is a cross-sectional view of the W-extension transistor 1000A, and the j-j section is a cross-sectional view of the L-extension transistor 1000B. In the W-extension transistor 1000A, a current flows perpendicularly to the i-i section, whereas in the L-extension transistor 1000B, a current flows in the direction of the j-j section.

A trench transistor used as a transistor constituting the comparator 51 desirably has a gate length L and a channel width W of, for example, about 0.2 to 5 µm. In particular, in order to enhance the effect of improving the transconductance Gm, it is most desirable that the channel-width (W) extension transistor used as the differential MOS (NT₁₁, NT₁₂) have a gate length L and a channel width W of about 0.5 to 2 µm and the channel-length (L) extension transistor used as the load MOS(Tr_{_lm}) have a gate length L and a channel width W of about 0.5 to 2 µm.

If a trench depth is too small in the shape of the trench (recessed portion) of the trench transistor, an extension of the effective area is small, so that the effect of improving a current and the transconductance Gm cannot be sufficiently obtained. If the trench depth is too large, ion implantation for preventing gate depletion hardly reaches the bottom of the trench. This increases the probability of gate depletion and causes a large difference in impurity concentration profile in the vertical direction between the upper part and the bottom of the trench. From this perspective, for example, a desirable trench depth is about 20 to 200 nm and the most desirable trench depth is about 50 to 130 nm.

As to the dimensions of the recessed portion/projecting portion of the trench transistor, a large pitch (recessed portion + projecting portion) causes a small extension of the effective area, so that the effect of improving a current and the transconductance Gm cannot be sufficiently obtained. The smaller the pitch, the greater the effect of improving a current and the transconductance Gm. However, an electric field concentration at a corner of the trench may reduce reliability, and the accuracy of finishing and a throughput may be adversely affected. From this perspective, for example, dimensions on the footprint of the recessed portion/projecting portion are preferably about 0.1 to 0.5 µm/0.1 to 0.5 µm and are most desirably about 0.02 to 0.2 µm/0.02 to 0.2 µm.

In order to compare the effects of a trench transistor with those of a planar transistor, a gate voltage V_{g}-drain current I_{d} was measured (Id) and noise was measured for a W-extension trench transistor manufactured according to Example 8 in the range of the most desirable layout.

Fig. 16A shows the measurement results of the gate voltage V_{g}-drain current I_{d} of the trench transistor and the planar transistor. Fig. 16B is a characteristic diagram of the gate voltage V_{g}-transconductance Gm calculated from the measurement results of Fig. 16A. As compared with the planar transistor having no trench with the same footprint, the trench transistor obtained the confirmed effect of increasing a drain current I_{d} by about 37% and the confirmed effect of increasing a transconductance maximum value Gmₘₐₓ by about 36% at a drain voltage V_{d} = 0.05 V. Fig. 16C shows the noise measurement results of the trench transistor and the planar transistor. As compared with the planar transistor, the trench transistor obtained the confirmed effect of reducing noise by about 50%.

### [Example 9]

Example 9, which is not according to the claimed invention, is an example of a method of forming (a method of manufacturing) a FIN transistor including a plurality of FINs (Fin FET). In this example, a method of forming main parts before the formation of contact electrodes will be described below.

Figs. 17A and 17B illustrate the process drawings (1) of the method of forming the FIN transistor according to Example 9. Figs. 18A and 18B illustrate process drawings (2).

Step 1 in Fig. 17A illustrates a state where element isolation regions 1102 are formed in a semiconductor substrate 1101. In step 2 of Fig. 17B, FIN portions 1103 are formed by etching the element isolation regions 1102. The technique of etching may be either wet etching or dry etching.

Subsequent to step 2, the step of implanting ions into the semiconductor substrate 1101 is performed, which is not illustrated, and then the step of forming a gate oxide film 1105 (Fig. 18A) is performed. The process then advances to step 3.

In step 3 of Fig. 18A, for example, polysilicon as a gate material is deposited by a CVD process, a gate electrode 1106 is formed by a dry etching process, and then a photoresist is removed.

In step 4 of Fig. 18B, an interlayer film 1107 is formed, contact electrodes 1108 are typically formed by lithography and a dry etching process, and then the photoresist is removed. The interlayer film 1107 is, for example, a laminate of silicon nitride (SiN) and silicon dioxide (SiO2).

Subsequent to step 4, the step of implanting ions into the semiconductor substrate 1101 is performed, which is not illustrated, the step of forming side walls is performed, and then the step of silicidation is performed.

Also in the FIN transistor used as a transistor constituting the comparator 51, a desirable gate length L is, for example, about 0.2 to 10 µm and a desirable channel width W is, for example, about 0.3 to 10 µm in an area on the footprint. A desirable pitch of semiconductor/device isolation in W direction is, for example, about 0.1 to 0.4/0.1 to 0.4 µm. In order to enhance the effect of improving the transconductance Gm, the most desirable pitch is, for example, about 0.2 to 0.3/0.1 to 0.2 µm. The FIN desirably has a height of, for example, about 10 to 200 nm and a depth of, for example, about 20 to 200 nm in order to enhance the effect of improving the transconductance Gm. The most desirable depth is, for example, about 50 to 130 nm.

### <Summary of first embodiment and second embodiment>

In the first embodiment, the channel-width (W) extension transistor is used as the differential MOS (NT₁₁, NT₁₂) constituting the differential circuit of the comparator 51. In the second embodiment, the channel-length (L) extension transistor is used as the load MOS (Tr_{_lm}) constituting the constant-current source 181. The application examples are not limited thereto.

### [Application examples of W-extension/L-extension transistors]

Fig. 19 shows a list of the application examples of W-extension/L-extension transistors, for constituent elements (1) to (6).

(1) For the differential MOS (NT₁₁, NT₁₂) including an N-channel MOS field-effect transistor constituting a differential circuit, a high transconductance Gm is necessary. Thus, a W-extension transistor is used in the embodiment according to the claimed invention
(2) For the load MOS (Tr_{_lm}) constituting the constant-current source 181, a high resistance and a low transconductance Gm are necessary. Thus, an L-extension transistor is preferable.
(3) For the current-mirror transistor (PT₁₁, PT₁₂) including a P-channel MOS field-effect transistor constituting a current mirror circuit, a low transconductance Gm is necessary. Thus, an L-extension transistor is used in the embodiment according to the claimed invention
(4) For the tail-current-source transistor (NT₁₃) including an N-channel MOS field-effect transistor, a high current and small variations in characteristics are necessary. Thus, a W-extension transistor is preferable. Alternatively, if variations in trench formation are disadvantageous, a planar transistor is preferable.
(5) For the P-channel MOS transistor (PT₁₃) of the second amplifier unit 512, the MOS transistor being paired with an active load, a high transconductance Gm is necessary. Thus, a W-extension transistor is preferable.
(6) For the N-channel MOS transistor (NT₁₄) constituting the current source of the second amplifier unit 512, a high current is necessary. Thus, a W-extension transistor is preferable.

As described above, the channel-width (W) extension transistor is suitable for all devices that require a low resistance and a large current, whereas the channel-length (L) extension transistor is suitable for all devices that require a high resistance and a low leak. In the comparator 51 having a circuit configuration illustrated in Fig. 4, planar transistors can be used for constituent elements other than the constituent elements for which the W-extension transistor or the L-extension transistor is used.

### [Laminated chip structure of imaging device]

As illustrated in Fig. 20, the imaging device 1 according to the first embodiment or the second embodiment may have a so-called laminated chip structure in which at least two semiconductor substrates (chips) of a first semiconductor substrate 201 and a second semiconductor substrate 202 are stacked.

In the imaging device 1 having a laminated chip structure, the pixel array part 11 including the pixels 2 arranged in a matrix form is formed on the first semiconductor substrate 201 of the first layer. At this point, the pixel 2 may have a pixel structure of a back-illuminated type that captures light from the back side of the first semiconductor substrate 201 when a substrate surface having a wiring layer is defined as a front side (front surface). However, the pixel structure is not limited to the back-illuminated type. The pixel structure may be a front-illuminated type.

On the second semiconductor substrate 202 of the second layer, a circuit part (Fig. 1) including the vertical scan unit 12, the column-signal processing unit 13, the reference-signal generating unit 14, the horizontal scan unit 15, the timing control unit 16, and the constant-current source circuit part 18 is formed. The first semiconductor substrate 201 of the first layer and the second semiconductor substrate 202 of the second layer are electrically connected to each other through connecting portions (not illustrated) such as a via (VIA) and Cu-Cu connection.

The two-layer structure in which the two semiconductor substrates 201 and 202 are stacked is illustrated as a laminated structure. The laminated structure may be a multilayer structure in which three or more semiconductor substrates are stacked.

The technique according to the first embodiment or the second embodiment is applied to the imaging device 1 having the laminated chip structure, thereby reducing the transistor size of the differential MOS constituting the comparator 51 of the analog-digital converter 50 formed on the second semiconductor substrate 202 or the load MOS constituting the constant-current source 181. Hence, the flexibility of a circuit layout on the second semiconductor substrate 202 can be improved.

### <Modification>

The technique according to the present disclosure was described on the basis of the preferred embodiments. The technique according to the present disclosure is not limited to the embodiments. The configurations and structures of the imaging device described in the embodiments are merely exemplary and thus can be changed as needed.

According to an embodiment of the invention, the technique according to the first embodiment and the technique according to the second embodiment are applied to the same imaging device at the same time.

Specifically, in the imaging device 1 illustrated in Fig. 1, the differential MOS constituting the comparator 51 of the analog-digital converter 50 may be a W-extension transistor while the load MOS constituting the constant-current source 181 may be an L-extension transistor.

### <Application examples>

The imaging device according to the first embodiment or the second embodiment can be used for, for example, various devices for sensing light such as visible light, infrared light, ultraviolet light, and X rays as illustrated in Fig. 21. Specific examples of various devices will be listed below.

- Devices that capture images used for viewing, such as digital cameras and mobile apparatuses with camera functions
- Devices used for transportation, such as in-vehicle sensors that capture front, rear, surrounding, and interior view images of automobiles, monitoring cameras that monitor traveling vehicles and roads, ranging sensors that measure a distance between vehicles, and the like, for safe driving such as automatic stop, recognition of a driver's condition, and the like
- Devices used for home appliances such as TVs, refrigerators, and air conditioners in order to photograph a user's gesture and perform device operations in accordance with the gesture.
- Devices used for medical treatment and healthcare, such as endoscopes and devices that perform angiography by receiving infrared light
- Devices used for security, such as monitoring cameras for crime prevention and cameras for personal authentication
- Devices used for beauty, such as a skin measuring device that captures images of the skin and a microscope that captures images of the scalp
- Devices used for sports, such as action cameras and wearable cameras for sports applications
- Devices used for agriculture, such as cameras for monitoring conditions of fields and crops

### <Application example of technique according to present disclosure>

The technique according to the present disclosure can be applied to various products. A more specific application example will be described below.

### [Electronic device according to present disclosure]

In the following description, the imaging device according to the first embodiment or the second embodiment is applied to an imaging system, e.g., a digital still camera or a video camera, a portable terminal having the imaging function, e.g., a cellular phone, and an electronic device, e.g., a copier in which the imaging device is used for an image reading unit.

### (Example of imaging system)

Fig. 22 is a block diagram illustrating a configuration example of an imaging system that is an example of an electronic device of the present disclosure.

As illustrated in Fig. 22, an imaging system 100 according to the present example includes an imaging optical system 101 including lenses, an imaging unit 102, a DSP (Digital Signal Processor) circuit 103, a frame memory 104, a display device 105, a recorder 106, an operation system 107, and a power supply system 108. In addition, the DSP circuit 103, the frame memory 104, the display device 105, the recorder 106, the operation system 107, and the power supply system 108 are connected to one another via a bus line 109.

The imaging optical system 101 captures incident light (image light) from a subject and forms an image on an image forming surface of the imaging unit 102. The imaging unit 102 converts an amount of incident light, which forms an image on the imaging surface by the optical system 101, into an electrical signal for each pixel and outputs the electrical signal as a pixel signal. The DSP circuit 103 performs typical camera signal processing, for example, white balance processing, demosaicing, or gamma correction.

The frame memory 104 is optionally used for storing data in the process of signal processing in the DSP circuit 103. The display device 105 includes a panel-type display device, e.g., a liquid crystal display device or an organic EL (electro luminescence) display device and displays a video or a still image captured by the imaging unit 102. The recorder 106 records the video or the still image captured by the imaging unit 102, in a portable semiconductor memory or recording media such as an optical disk and an HDD (Hard Disk Drive).

The operation system 107 issues operation commands for various functions of the imaging system 100 in response to a user operation. The power supply system 108 optionally supplies various power supplies serving as operation power supplies for the DSP circuit 103, the frame memory 104, the display device 105, the recorder 106, and the operation system 107, to the targets of supply.

In the imaging system 100 configured thus, the imaging device according to the foregoing embodiments may be used as the imaging unit 102. The imaging device can shrink the layout of circuit elements without increasing random noise, thereby contributing to the size reduction of the imaging system 100.

### [Example of application to mobile body]

The technology of the present disclosure (the present technology) can be applied in various products. For example, the technique according to the present disclosure may be implemented as an imaging device mounted on any kind of mobile body such as an automobile, an electric vehicle, a hybrid electric vehicle, a motorcycle, a bicycle, a personal mobility, an airplane, a drone, a ship, a robot, a construction machine, and an agricultural machine (tractor).

Fig. 23 is a block diagram schematically illustrating a configuration example of a vehicle control system that is an example of a mobile-body control system to which the technique according to the present disclosure is applicable.

A vehicle control system 12000 includes a plurality of electronic control units connected to one another via a communication network 12001. In the example illustrated in Fig. 23, the vehicle control system 12000 includes a drive system control unit 12010, a body system control unit 12020, an outside-vehicle information detection unit 12030, an inside-vehicle information detection unit 12040, and an integrated control unit 12050. In addition, as functional configurations of the integrated control unit 12050, a microcomputer 12051, a sound image output unit 12052, and an in-vehicle network interface I/F(interface) 12053 are illustrated.

The drive system control unit 12010 controls an operation of a device related to a drive system of a vehicle according to various programs. For example, the drive system control unit 12010 functions as a control device for a driving force generator for generating a driving force of a vehicle such as an internal combustion engine or a driving motor, a driving force transmission mechanism for transmitting a driving force to wheels, a steering mechanism for adjusting a turning angle of a vehicle, and a braking device that generates a braking force of a vehicle, and the like.

The body system control unit 12020 controls operations of various devices equipped in a vehicle body in accordance with various programs. For example, the body system control unit 12020 functions as a control device of a keyless entry system, a smart key system, a power window device, or various lamps such as a head lamp, a back lamp, a brake lamp, a turn signal, or a fog lamp. In this case, radio waves transmitted from a portable device that substitutes for a key or signals of various switches can be input to the body system control unit 12020. The body system control unit 12020 receives inputs of these radio waves or signals and controls the door lock device, the power window device, the lamps or the like of a vehicle.

The outside-vehicle information detection unit 12030 detects information on the outside of the vehicle having the vehicle control system 12000 mounted thereon. For example, an imaging unit 12031 is connected to the outside-vehicle information detection unit 12030. The outside-vehicle information detection unit 12030 causes the imaging unit 12031 to capture an image outside the vehicle and receives the captured image. The outside-vehicle information detection unit 12030 may perform a distance detection process or an object detection process for people, vehicles, obstacles, signs, and characters on roads on the basis of the received images.

The imaging unit 12031 is an optical sensor that receives light and outputs an electrical signal according to the amount of received light. The imaging unit 12031 can also output the electrical signal as an image and ranging information. In addition, light received by the imaging unit 12031 may be visible light or may be invisible light such as infrared light.

The inside-vehicle information detection unit 12040 detects information inside the vehicle. For example, a driver state detection unit 12041 that detects a state of a driver is connected to the inside-vehicle information detection unit 12040. The driver state detection unit 12041 includes, for example, a camera that captures an image of the driver, and the inside-vehicle information detection unit 12040 may calculate a degree of fatigue or concentration of the driver or may determine whether or not the driver is dozing on the basis of detection information input from the driver state detection unit 12041.

The microcomputer 12051 can calculate a control target value of the driving force generation device, the steering mechanism, or the braking device on the basis of information acquired by the outside-vehicle information detection unit 12030 or the inside-vehicle information detection unit 12040 inside and outside the vehicle, and output a control command to the drive system control unit 12010. For example, the microcomputer 12051 can perform cooperative control for the purpose of implementing functions of an ADAS (advanced driver assistance system) including vehicle collision avoidance, impact mitigation, following traveling based on an inter-vehicle distance, vehicle speed maintenance driving, vehicle collision warning, and vehicle lane deviation warning.

Further, the microcomputer 12051 can perform cooperative control for the purpose of automated driving or the like in which autonomous travel is performed without depending on operations of the driver, by controlling the driving force generator, the steering mechanism, or the braking device and the like on the basis of information about the surroundings of the vehicle, the information being acquired by the outside-vehicle information detection unit 12030 or the inside-vehicle information detection unit 12040.

In addition, the microcomputer 12051 can output a control command to the body system control unit 12020 based on the information acquired by the outside-vehicle information detection unit 12030 outside the vehicle. For example, the microcomputer 12051 can perform cooperative control for the purpose of preventing glare, such as switching from a high beam to a low beam, by controlling the headlamp according to the position of a preceding vehicle or an oncoming vehicle detected by the outside-vehicle information detection unit 12030.

The sound image output unit 12052 transmits an output signal of at least one of sound and an image to an output device capable of visually or audibly notifying a passenger or the outside of the vehicle of information. In the example of Fig. 23, an audio speaker 12061, a display unit 12062, and an instrument panel 12063 are illustrated as examples of the output device. The display unit 12062 may include, for example, at least one of an onboard display and a head-up display.

Fig. 24 is a diagram illustrating an example of the installation position of the imaging unit 12031.

In Fig. 24, a vehicle 12100 includes imaging units 12101, 12102, 12103, 12104, and 12105 as the imaging unit 12031.

The imaging units 12101, 12102, 12103, 12104, and 12105 are provided at positions such as a front nose, side-view mirrors, a rear bumper, a back door, and an upper portion of a windshield in a vehicle interior of the vehicle 12100, for example. The imaging unit 12101 provided on the front nose and the imaging unit 12105 provided in the upper portion of the windshield in the vehicle interior mainly acquire images in front of the vehicle 12100. The imaging units 12102 and 12103 provided on the side mirrors mainly acquire images on the lateral sides of the vehicle 12100. The imaging unit 12104 provided on the rear bumper or the back door mainly acquires images behind the vehicle 12100. Front view images acquired by the imaging units 12101 and 12105 are mainly used for detection of preceding vehicles, pedestrians, obstacles, traffic signals, traffic signs, lanes, and the like.

Examples of imaging ranges of the imaging units 12101 to 12104 are illustrated in Fig. 24. An imaging range 12111 indicates the imaging range of the imaging unit 12101 provided at the front nose, imaging ranges 12112 and 12113 respectively indicate the imaging ranges of the imaging units 12102 and 12103 provided at the side mirrors, and an imaging range 12114 indicates the imaging range of the imaging unit 12104 provided at the rear bumper or the back door. For example, a bird's-eye view image of the vehicle 12100 as viewed from above can be obtained by superimposing image data captured by the imaging units 12101 to 12104.

At least one of the imaging units 12101 to 12104 may have the function of acquiring distance information. For example, at least one of the imaging units 12101 to 12104 may be a stereo camera including a plurality of imaging elements or may be an imaging element having pixels for phase difference detection.

For example, the microcomputer 12051 can extract, particularly, a closest three-dimensional object on a path through which the vehicle 12100 is traveling, which is a three-dimensional object traveling at a predetermined speed (for example, 0 km/h or higher) in the substantially same direction as the vehicle 12100, as a preceding vehicle by acquiring a distance to each three-dimensional object in the imaging ranges 12111 to 12114 and temporal change in the distance (a relative speed with respect to the vehicle 12100) on the basis of distance information obtained from the imaging units 12101 to 12104. Furthermore, the microcomputer 12051 can set an inter-vehicle distance to be secured in advance in front of a preceding vehicle and can perform automated brake control (also including following stop control) or automated acceleration control (also including following start control). This can perform cooperative control for the purpose of, for example, autonomous driving in which the vehicle autonomously travels without the need for driver's operations.

For example, the microcomputer 12051 can classify and extract three-dimensional data regarding three-dimensional objects into other three-dimensional objects such as a twowheeled vehicle, an ordinary vehicle, a large-size vehicle, a pedestrian, and an electric pole on the basis of distance information obtained from the imaging units 12101 to 12104 and can use the other three-dimensional objects to perform automated avoidance of obstacles. For example, the microcomputer 12051 identifies obstacles in the vicinity of the vehicle 12100 as obstacles that can be visually recognized by the driver of the vehicle 12100 and obstacles that are difficult to visually recognize. In addition, the microcomputer 12051 determines a collision risk indicating a degree of risk of collision with each obstacle. When the collision risk is equal to or greater than a set value and there is a possibility of collision, the microcomputer 12051 outputs a warning to the driver via the audio speaker 12061 or the display unit 12062 and performs forced deceleration or avoidance steering via the drive system control unit 12010, enabling driving assistance for collision avoidance.

At least one of the imaging units 12101 to 12104 may be an infrared camera that detects infrared light. For example, the microcomputer 12051 can recognize a pedestrian by determining whether or not a pedestrian is present in captured images of the imaging units 12101 to 12104. A pedestrian is recognized through, for example, a procedure of extracting feature points in the captured images of the imaging units 12101 to 12104 serving as infrared cameras, and a procedure of performing pattern matching processing on a series of feature points indicating a contour of an object to determine whether or not the object is a pedestrian. When the microcomputer 12051 determines that pedestrians are in the images captured by the imaging units 12101 to 12104 and recognizes the pedestrians, the sound image output unit 12052 controls the display unit 12062 such that rectangular contour lines for emphasis are superimposed and displayed on the recognized pedestrians. In addition, the sound image output unit 12052 may control the display unit 12062 so that an icon or the like indicating a pedestrian is displayed at a desired position.

The example of the vehicle control system to which the technique according to the present disclosure is applicable has been described above. The technique according to the present disclosure is applicable to the imaging unit 12031 or the like among the configurations described above. The application of the technique according to the present disclosure to the imaging unit 12031 or the like can shrink the layout of circuit elements without increasing random noise, thereby contributing to the chip size reduction of the imaging unit 12031 or the like.

### [Reference Signs List]

1 Imaging device (CMOS image sensor)
2 Pixel
11 Pixel array part
12 Vertical scan unit
13 Column signal processing unit
14 Reference-signal generating unit
15 Horizontal scan unit
16 Timing control unit
17 Output line
18 Constant-current source circuit part
21 Photodiode (photoelectric conversion element)
22 Transfer transistor
23 Reset transistor
24 Amplification transistor
25 Selection transistor
31(31₁ to 31ₘ) Pixel control line
32(32₁ to 32ₙ) Vertical signal line
50 Analog-digital converter
51 Comparator
52 Counter circuit
53 Latch circuit
100 Imaging system
110 Planar transistor
120, 130, 140, 160, 170, 180 Trench transistor
150 FIN transistor
1000A Channel-width(W) extension transistor
1000B Channel-width(L) extension transistor
NT₁₁ First differential transistor
NT₁₂ Second differential transistor
NT₁₃ Tail-current-source transistor
C₁₁ First capacitive element
C₁₂ Second capacitive element
PT₁₁ First current-mirror transistor
PT₁₂ Second current-mirror transistor
Tr_{_lm} Load MOS

## Claims

1. An imaging device (1) comprising:
a pixel array part (11) in which pixels (2) are disposed, the pixel (2) including a photoelectric conversion element (21); and
an analog-digital converter (50) configured to convert an analog signal outputted from each of the pixels (2) of the pixel array part (11) into a digital signal,
wherein
the analog-digital converter (50) includes a comparator (51) configured to compare, with a reference signal, the analog signal outputted from each of the pixels (2) of the pixel array part (11), wherein
the comparator (51) includes a differential circuit, and wherein
a transistor (NT11, NT12) constituting the differential circuit is a trench transistor and has a three-dimensional structure (120; 130; 140; 1000A;) including a channel parallel to a direction of a current flow, wherein the three-dimensional structure has a at least one recess (125; 135; 145) and at least one projection (126; 136; 146) being placed alternately in a direction perpendicular to the current flow, and forms the channel such that current passes through all of a top surface, sides, and undersurfaces of the channel including the at least one recessed portion and the at least one projecting portion, or
wherein the comparator (51) includes a current mirror circuit, and wherein
a transistor (PT11; PT12) constituting the current mirror circuit is a trench transistor and has a three-dimensional structure (160; 170; 180; 1000B) including a channel perpendicular to a direction of a current flow, wherein the three-dimensional structure has at least one recess (165; 175; 185) and at least one projection (166; 176; 186) being placed alternately in a direction parallel to the current flow, and forms the channel such that current passes through all of a top surface, sides, and undersurfaces of the channel including the at least one recessed portion and the at least one projecting portion.

2. The imaging device (1) according to claim 1, further including a constant-current source circuit part (18) having a constant-current source (181) connected to a vertical signal line (32) provided for a column array of the pixel array part (11),
wherein
a transistor (Tr_{_lm}) constituting the constant-current source (181) has a three-dimensional structure including a channel perpendicular to a direction of a current flow, wherein the three-dimensional structure has at least one recess (165; 175; 185) and at least one projection (166; 176; 186) being placed alternately in a direction parallel to the current flow, and forms the channel such that current passes through all of a top surface, sides, and undersurfaces of the channel including the at least one recessed portion and the at least one projecting portion.

3. An electronic device comprising the imaging device (1) according to claim 1.

## Patentansprüche

1. Bildgebungsvorrichtung (1), umfassend:
einen Pixelarrayteil (11), in dem Pixel (2) angeordnet sind, das Pixel (2) einschließlich ein photoelektrisches Umwandlungselement (21); und
einen Analog-Digital-Wandler (50), der konfiguriert ist, um ein analoges Signal, das von jedem der Pixel (2) des Pixelarrayteils (11) ausgegeben wird, in ein digitales Signal umzuwandeln,
wobei
der Analog-Digital-Wandler (50) einen Komparator (51) einschließt, der konfiguriert ist, um, mit einem Referenzsignal das analoge Signal, das von jedem der Pixel (2) des Pixelarrayteils (11) ausgegeben wird, zu vergleichen, wobei
der Komparator (51) eine Differenzialschaltung einschließt, und wobei
ein Transistor (NT11, NT12), der die Differenzialschaltung bildet, ein Trench-Transistor ist und eine dreidimensionale Struktur (120; 130; 140; 1000A;) einschließlich eines Kanals parallel zu einer Richtung eines Stromflusses aufweist, wobei die dreidimensionale Struktur mindestens eine Vertiefung (125; 135; 145) und mindestens einen Vorsprung (126; 136; 146) aufweist, die abwechselnd in einer Richtung senkrecht zu dem Stromfluss platziert sind, und den Kanal derart ausbildet, dass Strom durch alle einer oberen Oberfläche, Seiten und Unteroberflächen des Kanals einschließlich des mindestens einen vertieften Abschnitts und des mindestens einen vorspringenden Abschnitts hindurchgeht, oder
wobei der Komparator (51) eine Stromspiegelschaltung einschließt, und wobei
ein Transistor (PT11; PT12), der die Stromspiegelschaltung bildet, ein Trench-Transistor ist und eine dreidimensionale Struktur (160; 170; 180; 1000B) einschließlich eines Kanals senkrecht zu einer Richtung eines Stromflusses aufweist, wobei die dreidimensionale Struktur mindestens eine Vertiefung (165; 175; 185) und mindestens einen Vorsprung (166; 176; 186) aufweist, die abwechselnd in einer Richtung parallel zu dem Stromfluss platziert sind, und den Kanal derart ausbildet, dass Strom durch alle einer oberen Oberfläche, Seiten und Unteroberflächen des Kanals einschließlich des mindestens einen vertieften Abschnitts und des mindestens einen vorspringenden Abschnitts hindurchgeht.

2. Bildgebungsvorrichtung (1) nach Anspruch 1, ferner einschließlich eines Konstantstromquellenschaltungsteils (18), das eine Konstantstromquelle (181) aufweist, die mit einer vertikalen Signalleitung (32) verbunden ist, die für ein Spaltenarray des Pixelarrayteils (11) bereitgestellt ist,
wobei
ein Transistor (Tr_{_lm}), der die Konstantstromquelle (181) bildet, eine dreidimensionale Struktur einschließlich eines Kanals senkrecht zu einer Richtung eines Stromflusses aufweist, wobei die dreidimensionale Struktur mindestens eine Vertiefung (165; 175; 185) und mindestens einen Vorsprung (166; 176; 186) aufweist, die abwechselnd in einer Richtung parallel zu dem Stromfluss platziert sind, und den Kanal derart ausbildet, dass Strom durch alle einer oberen Oberfläche, Seiten und Unteroberflächen des Kanals einschließlich des mindestens einen vertieften Abschnitts und des mindestens einen vorspringenden Abschnitts hindurchgeht.

3. Elektronische Vorrichtung, umfassend einen Bildgebungsvorrichtung (1) nach Anspruch 1.

## Revendications

1. Dispositif d'imagerie (1) comprenant :
une partie réseau de pixels (11) dans laquelle des pixels (2) sont disposés, le pixel (2) comportant un élément de conversion photoélectrique (21) ; et
un convertisseur analogique-numérique (50) configuré pour convertir un signal analogique délivré à partir de chacun des pixels (2) de la partie réseau de pixels (11) en un signal numérique,
dans lequel
le convertisseur analogique-numérique (50) comporte un comparateur (51) configuré pour comparer, à un signal de référence, le signal analogique délivré à partir de chacun des pixels (2) de la partie réseau de pixels (11), dans lequel
le comparateur (51) comporte un circuit différentiel, et dans lequel
un transistor (NT11, NT12) constituant le circuit différentiel est un transistor à tranchée et a une structure tridimensionnelle (120 ; 130 ; 140 ; 1000A) comportant un canal parallèle à une direction d'un flux de courant, dans lequel la structure tridimensionnelle a au moins un évidement (125 ; 135 ; 145) et au moins une saillie (126 ; 136 ; 146) étant placée alternativement dans une direction perpendiculaire au flux de courant, et forme le canal de telle sorte que du courant traverse l'ensemble d'une surface supérieure, des côtés et des surfaces inférieures du canal, y compris l'au moins une partie évidement et l'au moins une partie saillie, ou
dans lequel le comparateur (51) comporte un circuit à miroir de courant, et dans lequel
un transistor (PT11 ; PT12) constituant le circuit à miroir de courant est un transistor à tranchée et a une structure tridimensionnelle (160 ; 170 ; 180 ; 1000A) comportant un canal perpendiculaire à une direction d'un flux de courant, dans lequel la structure tridimensionnelle a au moins un évidement (165 ; 175 ; 185) et au moins une saillie (166 ; 176 ; 186) étant placée alternativement dans une direction parallèle au flux de courant, et forme le canal de telle sorte que du courant traverse l'ensemble d'une surface supérieure, des côtés et des surfaces inférieures du canal, y compris l'au moins une partie évidement et l'au moins une partie saillie.

2. Dispositif d'imagerie (1) selon la revendication 1, comportant en outre une partie circuit de source de courant constant (18) ayant une source de courant constant (181) connectée à une ligne de signal verticale (32) fournie pour un réseau de colonnes de la partie réseau de pixels (11), dans lequel
un transistor (Tr_{_lm}) constituant la source de courant constant (181) a une structure tridimensionnelle comportant un canal perpendiculaire à une direction d'un flux de courant, dans lequel la structure tridimensionnelle a au moins un évidement (165 ; 175 ; 185) et au moins une saillie (166 ; 176 ; 186) étant placée alternativement dans une direction parallèle au flux de courant, et forme le canal de telle sorte que du courant traverse l'ensemble d'une surface supérieure, des côtés et des surfaces inférieures du canal, y compris l'au moins une partie évidement et l'au moins une partie saillie.

3. Dispositif électronique comprenant le dispositif d'imagerie (1) selon la revendication 1.
